(19) Europäisches Patentamt / European Patent Office / Office européen des brevets

(11) **EP 3 048 486 B1**

(12) **EUROPÄISCHE PATENTSCHRIFT**

(45) Veröffentlichungstag und Bekanntmachung des Hinweises auf die Patenterteilung:
**06.06.2018   Patentblatt 2018/23**

(51) Int Cl.:
***G03F 7/20*** (2006.01)

(21) Anmeldenummer: **16000098.0**

(22) Anmeldetag: **15.01.2016**

(54) **PROJEKTIONSBELICHTUNGSANLAGE MIT MANIPULATOR SOWIE VERFAHREN ZUM STEUERN EINER PROJEKTIONSBELICHTUNGSANLAGE**

PROJECTION EXPOSURE SYSTEM WITH MANIPULATOR AND METHOD FOR CONTROLLING A PROJECTION EXPOSURE SYSTEM

INSTALLATION D'ECLAIRAGE PAR PROJECTION DOTEE D'UN MANIPULATEUR ET PROCEDE DE COMMANDE D'UNE INSTALLATION D'ECLAIRAGE PAR PROJECTION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.01.2015   DE 102015201020**

(43) Veröffentlichungstag der Anmeldung:
**27.07.2016   Patentblatt 2016/30**

(73) Patentinhaber: **Carl Zeiss SMT GmbH**
**73447 Oberkochen (DE)**

(72) Erfinder:
• **BITTNER, Boris**
**91154 Roth (DE)**
• **WALTER, Holger**
**73453 Abtsgmünd (DE)**

(74) Vertreter: **Zeuner Summerer Stütz**
**Nußbaumstrasse 8**
**80336 München (DE)**

(56) Entgegenhaltungen:
**DE-A1-102008 042 356     DE-A1-102012 212 757**
**DE-B3-102012 205 096**

**Beschreibung**

Hintergrund der Erfindung

Die Erfindung betrifft ein Verfahren zum Steuern einer Projektionsbelichtungsanlage für die Mikrolithographie mit einem Projektionsobjektiv sowie mindestens einem in einem Strahlengang des Projektionsobjektivs angeordneten optischen Manipulator, welcher eine Vielzahl von über einen Querschnitt des Strahlengangs verteilten Zonen mit individuell einstellbarer optischer Wirkung im Strahlengang aufweist.

Weiterhin betrifft die Erfindung eine Projektionsbelichtungsanlage für die Mikrolithographie mit einem Projektionsobjektiv zum Abbilden eines Musters aus einer Objektebene des Projektionsobjektivs in eine Bildebene des Projektionsobjektivs und mindestens einen optischen Manipulator in einem Strahlengang des Projektionsobjektivs, wobei der optische Manipulator eine Vielzahl von über einen Querschnitt des Strahlengangs verteilten Zonen mit individuell einstellbarer optischer Wirkung im Strahlengang aufweist.

Mikrolithographische Projektionsbelichtungsanlagen werden insbesondere bei der Herstellung von integrierten Schaltkreisen oder anderen mikro- oder nanostrukturierten Bauelementen verwendet und dienen zur Abbildung eines Musters einer Maske oder eines Retikels auf eine fotosensitive Schicht eines Substrats. Hierfür enthält eine herkömmliche Projektionsbelichtungsanlage eine Lichtquelle und ein Beleuchtungssystem, das von der Lichtquelle emittierte elektromagnetische Strahlung aufbereitet und auf das Muster richtet. Mit einem Projektionsobjektiv der Projektionsbelichtungsanlage wird ein von dem Beleuchtungssystem beleuchteter Abschnitt des Musters auf die fotosensitive Schicht des Substrats abgebildet. Als Substrat werden in der Regel so genannte Wafer aus Halbleitermaterial verwendet.

Die fortschreitende Miniaturisierung der Strukturen von Halbleiterbauelementen und der Bedarf an schnelleren Herstellungsprozessen mit kürzeren Belichtungszeiten führt zu immer höheren Anforderungen an die Abbildungseigenschaften der Projektionsbelichtungsanlagen und insbesondere der Projektionsobjektive. Die Abbildung des Musters auf die fotosensitive Schicht sollte während der gesamten Betriebsdauer der Projektionsbelichtungsanlage mit möglichst kleinen Abbildungsfehlern erfolgen.

Neben Abbildungsfehlern infolge von Fertigungs- und Montagetoleranzen sind auch erst während eines Betriebs auftretende Abbildungsfehler bekannt. So kann es bei optischen Elementen an Orten, die über längere Zeit einer besonders hohen Lichtintensität ausgesetzt sind, zum Auftreten von Alterungseffekten, beispielsweise zu einer Verdichtung (engl. compaction) des Materials, und somit zu einer lokal begrenzten Formänderung kommen. Eine weitere Ursache für betriebsbedingte Abbildungsfehler ist die unvermeidbare Absorption eines Teils der zur Belichtung verwendeten elektromagnetischen Strahlung in den optischen Elementen des Projektionsobjektivs. Die dabei absorbierte Leistung führt zu einer inhomogenen Erwärmung der optischen Elemente, wodurch Änderungen des Brechungsindex, Ausdehnungen und mechanische Spannungen auftreten. Durch diesen als "Lens-Heating" bezeichneten Effekt kommt es zu Aberrationen der sich in dem Projektionsobjektiv ausbreitenden Wellenfront. Das Lens-Heating stellt durch die erwünschte Leistungssteigerung der verwendeten elektromagnetischen Strahlung und die fortschreitende Miniaturisierung ein zunehmendes Problem bei der Halbleiterlithographie dar.

Da die Möglichkeit zur dynamischen Korrektur von im Betrieb auftretenden oder sich ändernden Abbildungsfehlern zunehmend wichtiger wird, enthalten moderne Projektionsbelichtungsanlagen eine Vielzahl von optischen Manipulatoren. Bei diesen optischen Manipulatoren lässt sich die optische Wirkung durch entsprechende Aktuatoren auf bestimmte Weise während des Betriebs ändern. Je nach gemessenem oder extrapoliertem Wellenfrontfehler kann mit den Manipulatoren während des Betriebs eine Wellenfrontdeformation induziert werden, die zumindest teilweise zur Kompensation des momentan auftretenden Wellenfrontfehlers geeignet ist.

Es sind verschiedene optische Manipulatoren für die Mikrolithographie bekannt, die eine Vielzahl von über den Querschnitt des Strahlengangs verteilte Zonen mit individuell einstellbarer optischer Wirkung aufweisen. Beispielsweise wird in US 2008/0204682 A1 ein Manipulator beschrieben, der ein optisches Element in Gestalt einer Linse mit Infrarot-Strahlung beaufschlagt. Hierbei wird die Linse zweidimensional variabel bestrahlt. Aufgrund von Absorption der Infrarot-Strahlung erfolgt eine entsprechende Erwärmung der bestrahlten Linsenabschnitte.

Weiterhin sind adaptive Spiegel als Manipulatoren für eine mikrolithographische Projektionsbelichtungsanlage bekannt. Zum Beispiel wird in DE 102011081603 A1 ein Spiegel mit einer piezoelektrischen Schicht und einer darüber angeordneten reflektierenden Beschichtung dargestellt. Über eine Vielzahl von über der piezoelektrischen Schicht verteilten Steuerelektroden lässt sich je nach angelegter Spannung eine unterschiedliche lokale Verformung der reflektierenden Beschichtung bewirken. Ein derart konfigurierter Spiegel ist auch in WO 2011/074319 beschrieben. Ferner sind z.B. aus JP 2013-161992 A oder JP 2013-106014 A adaptive Spiegel bekannt, bei denen Aktuatoren in Gestalt von Piezoaktuatoren oder Ultraschallmotoren an verschiedenen Punkten an der Rückseite des Spiegels angreifen. Es kann sich der Spiegel somit in einzeln oder kombiniert aktuierte Zonen aufgeteilt vorgestellt werden.

Ferner wird in WO 2008/034636 A2 ein strombetriebener thermischer Manipulator mit einer planparallelen Quarzplatte beschrieben. Die Platte enthält eine zweidimensionale Matrix aus Heizzonen, welche sich über Leiterbahnen und ohmsche Strukturen individuell beheizen lassen. Durch Einstellen der eingebrachten elektrischen Leistung lässt sich für jede Zone eine individuelle Temperatur und somit ein bestimmter Brechungsindex einstellen.

Weitere Projektionsbelichtungsanlagen mit optischen Manipulatoren im Strahlengang des Projektionsobjektivs sind offenbart in DE 10 2012 212757 A1, DE 10 2012 205096 B3, DE 10 2008 042356 A1.

Zur Kompensation von während des Betriebs einer Projektionsbelichtungsanlage auftretenden oder sich ändernden Wellenfrontfehlern muss jede Zone der beschriebenen Manipulatoren mit einem geeigneten Stellwegbefehl so angesteuert werden, dass insgesamt eine möglichst optimale Korrektur erzielt wird. Dabei sind bei der Bestimmung der Stellwege auch die Stellmöglichkeiten anderer Manipulatoren der Projektionsbelichtungsanlage zu berücksichtigen. Außerdem müssen eine Reihe von Randbedingungen beachtet werden. Zum Beispiel kann der Stellweg für eine Zone auch benachbarten Zonen beeinflussen oder deren Stellwege beschränken. Bei thermischen Manipulatoren muss zudem die thermische Neutralität über alle Zonen eingehalten werden, um eine Beeinträchtigung benachbarter Strukturen zu vermeiden. Die Bestimmung der Stellwege zur Kompensation eines gemessenen Wellenfrontfehlers führt daher zu einem sehr komplexen Optimierungsproblem, das in der Regel nicht mehr in Echtzeit während des Betriebs der Projektionsbelichtungsanlage gelöst werden kann.

Herkömmlich werden daher die Stellwege aller Zonen und auch der anderen in der Projektionsbelichtungsanlage vorgesehenen Manipulatoren für bestimmte Wellenfrontfehler, beispielsweise für bestimmte Zernike-Koeffizienten, im Voraus berechnet und als Stellwegvektoren in einem Speicher für eine Steuereinheit der Projektionsbelichtungsanlage bereitgestellt. Die Steuereinheit generiert anschließend während des Betriebs für einen gemessenen oder extrapolierten Wellenfrontfehler mit Hilfe der gespeicherten Stellwegvektoren einen zur Kompensation des Wellenfrontfehlers geeigneten Stellwegvektor mit Stellwegen für alle Zonen.

Ein Nachteil dieser Vorgehensweise ist, dass die zuvor berechneten und bereitgestellten Stellwegvektoren einen Manipulator mit einer Stellwegcharakteristik innerhalb einer bestimmten Sollvorgabe voraussetzen. Kommt es während des Betriebs durch eine Störung zu einer von der Sollvorgabe abweichenden Stellwegcharakteristik bei einer oder mehreren Zonen, kann diese bei einer Generierung eines Stellwegvektors nicht berücksichtigt werden. Ein Wellenfrontfehler wird daher nicht mehr optimal korrigiert. Da eine erneute Berechnung aller bereitgestellten Stellwegvektoren unter Berücksichtigung der abweichenden Stellwegcharakteristik zu zeitaufwendig ist, müssen die mangelhaften Komponenten letztendlich ausgetauscht werden.

Ein Beispiel für eine solche Störung ist ein elektrischer Kurzschluss zwischen zwei benachbarten Zonen eines thermischen Manipulators, wodurch beide Zonen stets mit der gleichen elektrischen Leistung betrieben werden. Weiterhin können optische Elemente, z.B. deformierbare Spiegel oder beheizbare Platten, bei denen die Stellwegcharakteristik einer oder mehrerer Zonen bereits nach der Fertigung zu stark von den Sollvorgaben abweicht, nicht für einen Manipulator verwendet werden.

Ein weiteres Beispiel für die vorstehend genannte Störung ist der Ausfall eines Kanals eines Manipulator, der ein optisches Element mit Infrarotlicht beaufschlagt, mit der Folge, dass lokal das Korrekturvermögen des Manipulators einbricht. Weiterhin können mechanische Komponente, die Druck oder Zug auf einen adaptiven Spiegel ausüben, von einem Ausfall betroffen sein. Ebenso kann z.B. die Kontaktierung eines adaptiven Spiegels mit einer piezo-elektrischen Schicht beschädigt werden, so dass einzelne aktuierbare Zonen nicht mehr angesteuert werden können.

Ein weiteres Problem ergibt sich dadurch, dass es bei der Generierung von Stellwegbefehlen zu einer Überschreitung eines vorgegebenen Stellwegbereichs eines oder mehrerer Stellwege kommen kann. Diese Stellwege könnten anschließend nicht mehr vollständig ausgeführt werden. Eine solche Stellwegabschneidung (engl. Clipping) durch Übersteuerung würde zu einer schlechteren Kompensation vorhandener Wellenfrontfehlern oder zur Erzeugung weiterer Wellenfrontfehler führen. Auch könnte die Steuerbefehlsgenerierung insgesamt instabil werden. Da die bekannten Steuerungsverfahren mit bereitgestellten Stellwegvektoren nur eine ungenügende Reaktion auf ein drohendes oder stattfindendes Clipping ermöglichen, werden die Manipulatoren von vornherein nicht bis an die Bereichsgrenzen gefahren. Hierdurch wird nachteilhaft nicht das komplette Leistungsvermögen der Manipulatoren ausgenutzt.

Zugrunde liegende Aufgabe

Es ist eine Aufgabe der Erfindung, ein Verfahren zum Steuern einer Projektionsbelichtungsanlage sowie eine Projektionsbelichtungsanlage bereitzustellen, womit die vorgenannten Probleme gelöst werden, und insbesondere auch bei einer Einschränkung in der Ausführbarkeit eines Stellwegs einer oder mehrerer Zonen eines optischen Manipulators eine ausreichende Kompensation eines Wellenfrontfehlers während des Betriebs ermöglicht wird.

Erfindungsgemäße Lösung

Die vorgenannte Aufgabe kann erfindungsgemäß beispielsweise gelöst werden durch ein Verfahren zum Steuern einer Projektionsbelichtungsanlage für die Mikrolithographie mit einem Projektionsobjektiv sowie mindestens einem in einem Strahlengang des Projektionsobjektivs angeordneten optischen Manipulator, welcher eine Vielzahl von über einen Querschnitt des Strahlengangs verteilten Zonen mit individuell einstellbarer optischer Wirkung im Strahlengang aufweist. Das Verfahren umfasst die folgenden Schritte: Bestimmen eines Wellenfrontfehlers in einem Bildfeld der Projektionsbelichtungsanlage, Generieren eines zur Korrektur des Wellenfrontfehlers geeigneten Stellwegvektors mit Stellwegen für jede Zone des optischen Manipulators mittels eines stellweggenerierenden Optimierungsalgorithmus auf Grundlage des bestimmten Wellenfrontfehlers, Ermitteln eines Einschränkungsparameters bezüglich des Stellwegs für mindestens eine Zone des optischen Manipulators, sowie Überprüfen der Stellwege des generierten Stellwegvektors auf Ausführbarkeit unter Berücksichtigung des ermittelten Einschränkungsparameters. Weiterhin werden die folgenden Schritte bei Vorliegen einer Einschränkung in der Ausführbarkeit ausgeführt: Beschaffen eines Korrekturwertvektors mit Korrekturwerten für mehrere der Zonen des optischen Manipulators auf Grundlage des Einschränkungsparameters und des generierten Stellwegvektors, Ermitteln eines korrigierten Stellwegvektors durch Korrektur der Stellwege des generierten Stellwegvektors anhand der entsprechenden Korrekturwerte des Korrekturwertvektors, wie etwa durch skaliertes Addieren der Korrekturwerte des Korrekturwertvektors zu den entsprechenden Stellwegen des generierten Stellwegvektors, und Einstellen der optischen Wirkung aller Zonen des optischen Manipulators mit Hilfe des korrigierten Stellwegvektors zur Kompensation des Wellenfrontfehlers.

Weiterhin kann die Aufgabe erfindungsgemäß gelöst werden durch die nachfolgend beschriebene Projektionsbelichtungsanlage für die Mikrolithographie. Die Projektionsbelichtungsanlage enthält ein Projektionsobjektiv zum Abbilden eines Musters aus einer Objektebene des Projektionsobjektivs in eine Bildebene des Projektionsobjektivs, sowie mindestens einen optischen Manipulator in einem Strahlengang des Projektionsobjektivs, wobei der optische Manipulator eine Vielzahl von über einen Querschnitt des Strahlengangs verteilten Zonen mit individuell einstellbarer optischer Wirkung im Strahlengang aufweist. Weiterhin umfasst die Projektionsbelichtungsanlage ein Bestimmungsmodul zum Bestimmen eines Wellenfrontfehlers in einem Bildfeld der Projektionsbelichtungsanlage, einen Stellweggenerator zum Generieren eines zur Korrektur des Wellenfrontfehlers geeigneten Stellwegvektors mit Stellwegen für jede Zone des optischen Manipulators mittels eines stellweggenerierenden Optimierungsalgorithmus auf Grundlage des bestimmten Wellenfrontfehlers, eine Prüfeinrichtung zum Ermitteln eines Einschränkungsparameters bezüglich des Stellwegs für mindestens eine Zone des optischen Manipulators und zum Überprüfen der Stellwege des generierten Stellwegvektors auf Ausführbarkeit unter Berücksichtigung des ermittelten Einschränkungsparameters, sowie eine Korrektureinrichtung zum Korrigieren des generierten Stellwegvektors bei einer Einschränkung der Ausführbarkeit mindestens eines Stellwegs. Die Korrektureinrichtung ist zum Beschaffen eines Korrekturwertvektors mit Korrekturwerten für mehrere der Zonen des optischen Manipulators basierend auf den Einschränkungsparameter und dem generierten Stellwegvektor und zum Ermitteln eines korrigierten Stellwegvektors durch Korrektur der Stellwege des generierten Stellwegvektors anhand der entsprechenden Korrekturwerte des Korrekturwertvektors, wie etwa durch skaliertes Addieren der Korrekturwerte des Korrekturwertvektors zu den entsprechenden Stellwegen des generierten Stellwegvektors, ausgebildet. Weiterhin umfasst die Projektionsbelichtungsanlage eine Aktuierungseinrichtung zum Einstellen aller Zonen des optischen Manipulators mit Hilfe des korrigierten Stellwegvektors zur Kompensation des Wellenfrontfehlers. Die erfindungsgemäße Projektionsbelichtungsanlage kann insbesondere einen Speicher zur Speicherung des generierten Stellwegvektors und insbesondere einen weiteren Speicher zur Speicherung von Korrekturwertvektoren umfassen.

Die Erfindung beruht auf dem Prinzip, einen während des Betriebs der Projektionsbelichtungsanlage mittels eines Optimierungsalgorithmus generierten und nicht vollständig ausführbaren Stellweg für mindestens eine Zone des optischen Manipulators durch korrigierte Stellwege für andere Zonen auszugleichen. Die durch den nicht ausführbaren Stellweg verursachte fehlerhafte optische Wirkung des Manipulators soll durch die mit den korrigierten Stellwegen erzeugte optische Wirkung der anderen Zonen kompensiert werden. Zu diesem Zweck findet zunächst eine Überprüfung der generierten Stellwege auf Grundlage eines ermittelten Einschränkungsparameters statt. Der Einschränkungsparameter gibt dazu Stellwegeinschränkungen für mindestens eine Zone vor. Wird für eine oder mehrere Zonen eine Einschränkung in der Ausführbarkeit des generierten Stellweges und somit ein nicht vollständig ausführbarer Stellweg festgestellt, erfolgt eine Korrektur des generierten Stellwegvektors mit Stellwegen für alle Zonen durch einen Korrekturwertvektor. Der Korrekturwertvektor enthält Korrekturwerte für mehrere, insbesondere für alle Zonen des optischen Manipulators und wird mit Hilfe der durch den Einschränkungsparameter vorgegebenen Stellwegeinschränkung und des generierten Stellwegvektors, insbesondere der darin enthaltenen, nicht ausführbaren Stellwege ermittelt. Die Korrektur wird beispielsweise durch komponentenweises Addieren des Korrekturwertvektors zum generierten Stellwegvektor durchgeführt. Der durch die Korrektur ermittelte korrigierte Stellwegvektor wird anstelle des generierten Stellwegvektors zum Einstellen aller Zonen des optischen Manipulators verwendet und erzeugt eine optische Wirkung des Manipulators, die durch den generierten Stellwegvektor erzeugt werden sollte.

Unter Stellweg wird hier nicht nur eine räumliche Verschiebung oder Drehung eines optischen Elements, sondern insbesondere auch eine lokale oder flächige Beaufschlagung eines optischen Elements mit Wärme, Kälte, Kräften, Momenten, Licht einer bestimmten Wellenlänge oder elektrischen Strömen verstanden. Eine mittels Manipulator-Aktuierung durchgeführte Änderung einer Zustandsgröße eines optischen Elements bzw. Manipulators um einen Stellweg ändert dessen optische Wirkung in einer spezifischen Weise.

Unter Stellwegvektor oder Korrekturwertvektor wird hier eine Zusammenfassung einer Mehrzahl von Stellwegen bzw. Korrekturwerten für jeweils verschiedene Zonen des optischen Manipulators verstanden. Dabei kann ein Stellwergvektor oder Korrekturwertvektor zusätzlich auch Stellwege bzw. Korrekturwerte für andere Manipulatoren der Projektionsbelichtungsanlage enthalten.

Mit dem erfindungsgemäßen Verfahren und der erfindungsgemäßen Projektionsbelichtungsanlage lassen sich sowohl ein optischer Manipulator mit einer oder mehreren fehlerhaften Zonen als auch generierte Stellwergvektoren weiterhin für eine Kompensation von Wellenfrontfehlern verwenden. Dabei ist eine Anpassung des Optimierungsalgorithmus zur eigentlichen Generierung von Stellwertvektoren nicht notwendig, was einen erheblichen Zeitbedarf bedeuten würde. Weiterhin kann eine Übersteuerung einer oder mehrerer Zonen des optischen Manipulators durch außerhalb eines Stellwegbereichs liegende Stellwege und eine daraus resultierende Stellwegabschneidung kompensiert werden.

Gemäß einer erfindungsgemäßen Ausführungsform des Verfahrens umfasst das Beschaffen des Korrekturwertvektors eine Auswahl eines Korrekturwertvektors aus einer Vielzahl von für die Projektionsbelichtungsanlage in einem Speicher bereitgestellten Korrekturwertvektoren. Mit anderen Worten, es wird ein vorab ermittelter Korrekturwertvektor aktiviert. Dieser Korrekturwertvektor kann vorab, d.h. vor dem Belichtungsbetrieb der Projektionsbelichtungsanlage, innerhalb oder außerhalb der Projektionsbelichtungsanlage berechnet worden sein. Durch diese besonders schnell durchführbare Beschaffung des Korrekturwertvektors wird ein Korrigieren des generierten Stellwegvektors während des Betriebs in Echtzeit erleichtert.

Gemäß einer weiteren erfindungsgemäßen Ausführungsform des Verfahrens umfasst das Beschaffen des Korrekturwertvektors folgende Schritte: Ermitteln eines Basiskorrekturvektors mit Basisstellwegen auf Grundlage des Einschränkungsparameters, Ermitteln eines Skalierungsfaktors auf Grundlage des generierten Stellwegvektors und des ermittelten Basiskorrekturvektors, sowie Berechnen des Korrekturwertvektors durch Skalieren des Basiskorrekturvektors mit dem ermittelten Skalierungsfaktor. Der oben aufgeführte Schritt des Ermitteln eines Basiskorrekturvektors mit Basisstellwegen auf Grundlage des Einschränkungsparameters kann auch vorab, d.h. vor dem Belichtungsbetrieb der Projektionsbelichtungsanlage, innerhalb oder außerhalb der Projektionsbelichtungsanlage durchgeführt werden.

Der Basiskorrekturvektor kann beispielsweise für einen nicht vollständig ausführbaren Stellweg einer Zone ermittelt werden und lässt sich durch Skalieren mit dem Skalierungsfaktor auch für viele andere nicht vollständig durchführbare Stellwege der Zone zur Korrektur des generierten Stellwegvektors verwenden. Entsprechendes gilt für durch den Einschränkungsparameter vorgegebene Stellwegeinschränkungen bei mehreren Zonen. Die Verwendung eines Basiskorrekturvektors vereinfacht somit wesentlich die Ermittlung von Korrekturwertvektoren für eine Vielzahl von unterschiedlichen generierten Stellwegvektoren.

Insbesondere umfasst dabei das Ermitteln des Basiskorrekturvektors eine Auswahl eines Basiskorrekturvektors aus einer Vielzahl von für die Projektionsbelichtungsanlage in einem Speicher bereitgestellten Basiskorrekturvektoren. Die Basiskorrekturvektoren können zum Beispiel zuvor mit einem Rechner für verschiedene Zonen und unterschiedliche stellwegeinschränkende Störungen bestimmt und anschließend in dem Speicher gespeichert werden. Das Ermitteln des Basiskorrekturvektors und damit auch die Korrektur eines generierten Stellwegvektors lässt sich so auch bei neu auftretenden, stellwegeinschränkenden Störungen einer oder mehrerer Zonen des optischen Manipulators unmittelbar durchführen.

Gemäß einer weiteren Ausführungsform der Erfindung gibt der Einschränkungsparameter einen maximal zulässigen Stellweg für mindestens eine Zone des optischen Manipulators vor. Als maximaler Stellweg kann beispielsweise die Grenze eines Stellwegbereichs für eine den Sollvorgaben entsprechende Zone verwendet werden. Auf diese Weise lässt sich eine Übersteuerung einer Zone durch einen während des Betriebs generierten, fehlerhaften Stellweg und eine daraus resultierende Stellwegabschneidung korrigieren.

Eine erfindungsgemäßen Ausführungsform des Verfahrens umfasst ein Prüfen einer Aktuatorcharakteristik der Zonen des optischen Manipulators auf Einhaltung einer Sollvorgabe für einen Stellwegbereich und ein Festlegen des Einschränkungsparameters auf einen maximal zulässigen Stellweg für eine fehlerhafte Zone mit einer von der Sollvorgabe abweichenden Aktuatorcharakteristik. Je nach Manipulator wird zum Beispiel eine Widerstandscharakteristik der elektrisch beheizbaren Zonen einer Platte oder eines anderen optischen Elements für einen thermischen Manipulator, die zur Verfügung stehende bzw. momentan genutzte Strahlungsleistung eines mit IR-Strahlung arbeitenden Manipulators oder die Deformierungscharakteristik der Zonen eines adaptiven Spiegels geprüft. Ein Manipulator mit einer von der Sollvorgabe abweichenden Aktuatorcharakteristik bei einer oder mehreren Zonen lässt sich weiterhin für eine Kompensation von Wellenfrontfehlern einsetzen.

Bei einer weiteren erfindungsgemäßen Ausführungsform des Verfahrens umfasst das Ermitteln des Basiskorrekturvektors bei Vorliegen einer fehlerhaften Zone des optischen Manipulators mit einem von einer Sollvorgabe abweichenden Stellwegbereichs die folgenden Schritte: Bestimmen eines maximalen Korrekturstellwegs für die fehlerhafte Zone basierend auf der Sollvorgabe und des tatsächlichen Stellwertbereichs, Bestimmen von maximalen Stellwegbereichen für alle anderen Zonen des Manipulators, und Lösen eines Optimierungsproblems mit dem maximalen Korrekturstellweg der fehlerhaften Zone, den maximalen Stellwegbereichen aller anderen Zonen und einer minimalen oder vorgegebenen Aberration als Zwangsbedingungen zur Bestimmung der Basisstellwege des Basiskorrekturvektors.

Als maximaler Korrekturstellweg kann beispielsweise eine Differenz der Grenzen eines Sollstellwertbereichs und des tatsächlichen Stellwertbereichs verwendet werden. Mit anderen Worten enthält der Basiskorrekturvektor als Lösung des Optimierungsproblems Basisstellwege für alle Zonen außer der fehlerhaften Zone, deren gemeinsame optische Wirkung der optischen Wirkung des real nicht ausführbaren maximalen Korrekturstellwegs entspricht. Der Basiskorrekturvektor lässt sich durch Skalieren schnell für weitere nicht vollständig ausführbare Stellwege der fehlerhaften Zone anpassen. Auf diese Weise wird eine in Echtzeit während des Betriebs durchführbare Ermittlung eines Korrekturwertvektors für eine Vielzahl von verschiedenen Stellwegvektoren mit einem auf Grund einer fehlerhaften Zone nicht vollständig ausführbaren Stellweg ermöglicht.

Gemäß einer weiteren erfindungsgemäßen Ausführungsform des Verfahrens erfolgt ein Prüfen einer Aktuatorcharakteristik der Zonen des optischen Manipulators zur Ermittlung eines Vorliegens einer fehlerhaften Zone und, bei Vorliegen einer fehlerhaften Zone, das Berechnen eines Basiskorrekturvektors während der Herstellung des optischen Manipulators, und es wird der optische Manipulator zusammen mit dem berechneten Basiskorrekturvektor für die Projektionsbelichtungsanlage bereitgestellt. Durch diese Maßnahme kann der Manipulator beziehungsweise das die Zonen aufweisende optische Element des Manipulators auch bei Vorliegen einer fehlerhaften Zone für die Projektionsbelichtungsanlage bereitgestellt und verwendet werden und muss nicht aussortiert werden.

Gemäß einer weiteren Ausführungsform basiert das Ermitteln des Skalierungsfaktors bei Vorliegen einer fehlerhafte Zone des optischen Manipulators mit einem von einer Sollvorgabe abweichenden Stellwegbereich auf einem Überschreitungswert des Stellwegbereichs durch den generierten Stellweg und einer Nominalauslegung des für die fehlerhafte Zone ermittelten Basiskorrekturvektors. Zum Beispiel kann mit einem Basisüberschreitungswert, für dessen Korrektur der Basiskorrekturvektor ausgelegt ist, als Skalierungsfaktor das Verhältnis von Überschreitungswert zu Basisüberschreitungswert ermittelt werden. Zusammen mit dem Basiskorrekturvektor für die fehlerhafte Zone ermöglicht der so bestimmte Skalierungsfaktor eine schnelle Ermittlung einer Vielzahl von unterschiedlichen Korrekturwertvektoren für Überschreitungen des Stellwegbereichs bei einer fehlerhaften Zone.

Gemäß einer weiteren Ausführungsform der Erfindung umfasst der optische Manipulator eine Bestrahlungseinrichtung sowie ein in einem Strahlengang des Projektionsobjektivs angeordnetes optisches Element. Die Zonen auf dem optischen Element werden von der Bestrahlungseinrichtung jeweils separat mit Strahlung einer Wellenlänge, welche von einer Belichtungswellenlänge der Projektionsbelichtungsanlage abweicht, derart bestrahlt, dass aufgrund einer Aufheizung der Zonen die optische Wirkung zur Kompensation des Wellenfrontfehlers erzielt wird. Die zur Aufheizung der Zonen verwendete Strahlung kann auch als Heizstrahlung bezeichnet werden. Wie bereits erwähnt, weist die Heizstrahlung eine Wellenlänge auf, die von der Belichtungswellenlänge der Projektionsbelichtungsanlage abweicht. Die Belichtungswellenlänge ist die Wellenlänge der zur Abbildung von Maskenstrukturen in die Bildebene der Projektionsbelichtungsanlage verwendeten Belichtungsstrahlung.

Die Wellenlänge der Heizstrahlung weicht vorzugsweise derart von der Belichtungswellenlänge ab, dass ein Großteil, insbesondere mindestens 80% oder 90% der auf das optische Element eingestrahlten Heizstrahlung von diesem absorbiert wird. Damit wird lediglich ein geringer Teil der Heizstrahlung von dem optischen Element im Strahlengang des Projektionsobjektivs weitergegeben, sodass ein im Strahlengang nachgelagertes optisches Element keine wesentliche Aufheizung erfährt. Das optische Element, auf welches die Heizstrahlung eingestrahlt wird kann z.B. eine Linse, eine strahlungsdurchlässige Platte oder ein Spiegel sein. Insbesondere kann das optische Element eines der optischen Elemente des Projektionsobjektivs sein, welche den Strahlengang des Projektionsobjektivs definieren. Das heißt, in diesem Fall dient das vom optischen Manipulator umfasste optische Element grundsätzlich der Führung der Belichtungsstrahlung im Strahlengang.

Im Fall, in dem das optische Element des optischen Manipulators eine Linse ist, erfolgt durch die Einstrahlung der Heizstrahlung eine Brechzahländerung im Linsenmaterial. Die zonenabhängige Aufheizung des Linsenmaterials führt zu einer lokal variierenden Brechzahländerung in der Linse, was eine Wellenfrontmanipulation zur Folge hat. Die Funktionsweise einer strahlungsdurchlässigen Platte ist analog. Im Fall, in dem das optische Element des Manipulators ein Spiegel ist, erfolgt durch die zonenabhängige Einstrahlung der Heizstrahlung aufgrund der daraus resultierenden ortsabhängigen Erwärmung eine Deformation der Spiegeloberfläche, welche ebenfalls eine Wellenfrontmanipulation zur Folge hat.

Gemäß einer Ausführungsform ist die jeweilige optische Wirkung der Zonen mittels jeweiliger Steuersignale einstellbar und weiterhin erfolgt ein Prüfen auf eine fehlerhafte Gleichschaltung der Steuersignale zweier Zonen. Bei Vorliegen einer fehlerhaften Gleichschaltung gibt der Einschränkungsparameter einen einheitlichen Stellweg für die beiden betroffenen Zonen vor.

Gemäß einer Ausführungsvariante ist der optische Manipulator als deformierbarer Spiegel konfiguriert, bei dem die optische Wirkung der Zonen mittels an einer piezoelektrischen Schicht anliegenden Steuerelektroden individuell einstellbar ist, und die fehlerhafte Gleichschaltung der Steuersignale zweier Zonen erfolgt durch einen Kurzschluss zweier benachbarter Steuerelektroden.

Gemäß einer weiteren Ausführungsvariante ist der optische Manipulator als strombetriebener thermischer Manipulator konfiguriert, bei dem die Steuersignale zur Einstellung der optischen Wirkung der Zonen durch individuelle elektrische Beheizung der Zonen erzeugt werden, wobei weiterhin das Prüfen auf ein fehlerhaftes Gleichschalten der Steuersignale zweier Zonen ein Prüfen auf einen elektrischen Kurzschluss in der Beheizung zweier benachbarter Zonen umfasst, der bewirkt, dass beide Zonen gleich stark beheizt werden, und der Einschränkungsparameter bei Vorliegen eines Kurzschlusses einen einheitlichen Stellweg für die beiden benachbarten Zonen vorgibt. Mit anderen Worten ist der optische Manipulator gemäß dieser Ausführungsvariante als strombetriebener thermischer Manipulator konfiguriert, bei dem die optische Wirkung der Zonen durch elektrische Beheizung individuell eingestellt wird, wobei weiterhin ein Prüfen auf einen elektrischen Kurzschluss in der Beheizung zweier benachbarter Zonen erfolgt, der bewirkt, dass beide Zonen gleich stark beheizt werden, und der Einschränkungsparameter bei Vorliegen eines Kurzschlusses einen einheitlichen Stellweg für die beiden benachbarten Zonen vorgibt. Das Prüfen auf einen elektrischen Kurzschluss kann insbesondere nach Inbetriebnahme des Manipulators erfolgen. Hierdurch wird ein Korrigieren der durch den einheitlichen Stellweg induzierten Störung ermöglicht. Der Manipulator kann auch mit einem Kurzschuss zwischen zwei benachbarten Zonen mittels der korrigierten Stellwege weiter verwendet werden.

Gemäß einer weiteren Ausführungsform des erfindungsgemäßen Verfahrens ist der optische Manipulator als strombetriebener thermischer Manipulator konfiguriert, bei dem die optische Wirkung der Zonen durch elektrische Beheizung individuell eingestellt wird, wobei weiterhin das Ermitteln des Basiskorrekturvektors umfasst: ein Berechnen eines Basiskorrekturvektors für zwei benachbarte, kurzgeschlossene Zonen des strombetriebenen thermischen Manipulators durch Lösen eines Optimierungsproblems mit vorgegebenen Differenz zwischen unterschiedlichen Stellwegen für die zwei kurzgeschlossenen Zonen, maximalen Stellwegbereichen für alle anderen Zonen des thermischen Manipulators und minimaler Aberration als Zwangsbedingungen zur Bestimmung der Basisstellwege des Basiskorrekturvektors. Als unterschiedliche Stellwege können zum Beispiel zwei Stellwege mit einer Basisdifferenz verwendet werden. Mit anderen Worten enthält der Basiskorrekturvektor als Lösung des Optimierungsproblems Basisstellwege für alle Zonen außer den zwei kurzgeschlossenen benachbarten Zonen, deren gemeinsame optische Wirkung den optischen Wirkungen der zwei real nicht ausführbaren, unterschiedlichen Stellwege für die kurzgeschlossen Zonen entspricht. Durch Skalieren kann der Basiskorrekturvektor schnell an andere bei den kurzgeschlossenen Zonen nicht ausführbare Stellwegdifferenzen angepasst werden. Hierdurch wird eine in Echtzeit während des Betriebs ausführbare Ermittlung eines Korrekturwertvektors für eine Vielzahl von verschiedenen Stellwegvektoren mit unterschiedlichen Stellwegen für die kurzgeschlossenen Zonen durchführbar.

Gemäß einer weiteren Ausführungsform ist die jeweilige optische Wirkung der Zonen mittels jeweiliger Steuersignale einstellbar und das Ermitteln des Basiskorrekturvektors umfasst weiterhin: ein Berechnen eines Basiskorrekturvektors für zwei Zonen des Manipulators, deren Steuersignale gleichgeschaltet sind. Dieses Berechnen erfolgt durch Lösen eines Optimierungsproblems mit vorgegebener Differenz zwischen unterschiedlichen Stellwegen für die zwei Zonen mit gleichgeschalteten Steuersignalen, maximalen Stellwegbereichen für alle anderen Zonen des optischen Manipulators und minimaler Aberration als Zwangsbedingungen zur Bestimmung der Basisstellwege des Basiskorrekturvektors.

Gemäß einer Ausführungsvariante ist der optische Manipulator als deformierbarer Spiegel, bei dem die optische Wirkung der Zonen mittels an einer piezoelektrischen Schicht anliegenden Steuerelektroden individuell einstellbar ist, oder als strombetriebener thermischer Manipulator, bei dem die optische Wirkung der Zonen durch elektrische Beheizung individuell einstellbar ist, konfiguriert. Das Berechnen des Basiskorrekturvektors erfolgt für zwei benachbarte, elektrisch kurzgeschlossene Zonen des optischen Manipulators. Gemäß der zweiten Variante ist damit der optische Manipulator als strombetriebener thermischer Manipulator konfiguriert, bei dem die optische Wirkung der Zonen durch elektrische Beheizung individuell eingestellt wird. Dabei umfasst das Ermitteln des Basiskorrekturvektors insbesondere weiterhin ein Berechnen eines Basiskorrekturvektors für eine Widerstandsabweichung einer oder mehrerer Zonen des strombetriebenen thermischen Manipulators durch Lösen eines Optimierungsproblems mit vorgegebenen maximal möglichen Stellwegen für die betroffenen Zonen, maximalen Stellwegbereichen für alle anderen Zonen des thermischen Manipulators und minimaler Aberration als Zwangsbedingungen zur Bestimmung der Basisstellwege des Basiskorrekturvektors.

Eine weitere erfindungsgemäße Ausführungsform umfasst ein Berechnen und Bereitstellen von Basiskorrekturvektoren für eine Vielzahl von möglichen Kurzschlüssen zwischen zwei benachbarten Zonen eines strombetriebenen thermischen Manipulators. Insbesondere wird für alle möglichen Kurzschlüsse zwischen allen benachbarten Zonen des Manipulators ein Basiskorrekturvektor berechnet und für die Projektionsbelichtungsanlage bereitgestellt. Durch diese Maßnahme steht unmittelbar beim Auftreten eines Kurzschlusses ein entsprechender Basiskorrekturvektor zum Ermitteln eines Korrekturwertvektors zur Verfügung.

Gemäß einer weiteren Ausführungsform der Erfindung basiert das Ermitteln des Skalierungsfaktors auf der Differenz der generierten Stellwege für die zwei Zonen mit gleichgeschalteten Steuersignalen, insbesondere die zwei benachbarten, kurzgeschlossenen Zonen, und einer Nominalauslegung des für die Zonen mit gleichgeschalteten Steuersignalen, insbesondere die kurzgeschlossenen Zonen, ermittelten Basiskorrekturvektors. Beispielsweise kann mit einer Basisdifferenz zwischen zwei unterschiedlichen Stellwegen, für dessen Korrektur der Basiskorrekturvektor ausgelegt ist, als Skalierungsfaktor das Verhältnis von der Differenz der Stellwege zur Basisdifferenz ermittelt werden. Zusammmen mit dem Basiskorrekturvektor für die kurzgeschlossenen Zonen vereinfacht der so bestimmte Skalierungsfaktor eine Ermittlung einer Vielzahl von unterschiedlichen Korrekturwertvektoren für generierte Stellwegvektoren mit unterschiedlichen, nicht ausführbaren Stellwegen für die kurzgeschlossenen Zonen.

Gemäß einer weiteren erfindungsgemäßen Ausführungsform des Verfahrens enthält der optische Manipulator eine für die Belichtungsstrahlung der Projektionsbelichtungsanlage transparente Platte, deren optische Wirkung temperaturabhängig ist, wobei die Zonen jeweils separate, elektrisch beheizbare Bereiche der Platte sind, und es erfolgt ein Einstellen der optischen Wirkung für jede Zone der transparenten Platte durch eine Beheizung entsprechend den Stellwegen des korrigierten Stellwegvektors. Eine solche Platte ermöglicht wegen der hohen Anzahl von Zonen eine sehr flexible Einstellung des Manipulators zur Kompensation von vielen unterschiedlichen Wellenfrontfehlern. Die Platte lässt sich bei dieser Ausführungsform auch mit fehlerhaften Zonen weiterhin zur Kompensation von Wellenfrontfehlern verwenden.

Gemäß einer weiteren erfindungsgemäßen Ausführungsform des Verfahrens enthält der optische Manipulator eine zweite, für die Belichtungsstrahlung der Projektionsbelichtungsanlage transparente Platte, deren optische Wirkung temperaturabhängig ist, wobei weitere Zonen des Manipulators jeweils separate, elektrisch beheizbare Bereiche der zweiten Platte sind, und es erfolgt ein Einstellen der optischen Wirkung für jede Zone beider Platten durch eine Beheizung entsprechend den Stellwegen des korrigierten Stellwegvektors. Mit dieser Ausführungsform kann ein solcher Manipulator mit einer sehr hohen Anzahl von Zonen auch bei einem stellwegeinschränkenden Defekt einer oder mehrerer Zonen weiterhin verwendet werden.

Gemäß einer weiteren erfindungsgemäßen Ausführungsform des Verfahrens umfasst der optische Manipulator einen deformierbaren Spiegel, wobei die Zonen jeweils deformierbare Bereiche einer reflektierenden Beschichtung des Spiegels sind, und es erfolgt ein Einstellen der optischen Wirkung für jede Zone des deformierbaren Spiegels durch eine Deformierung entsprechend den Stellwegen des korrigierten Stellwegvektors. Die Deformierung kann mittels piezoelektrischer Schichten, durch Druck oder Zug von Aktuatoren in Gestalt von Stößeln oder durch die Beaufschlagung mit Heizlicht bewirkt werden. Manipulatoren mit einem solchen adaptiven Spiegel werden insbesondere bei Projektionsbelichtungsanlagen mit einer Belichtungsstrahlung im tiefen ultravioletten Spektralbereich (DUV und VUV) sowie im extremen ultravioletten Spektralbereich (EUV) verwendet. Auch diese Manipulatoren lassen sich nun mit einer stellwegeinschränkenden Störung bei einer oder mehreren Zonen weiterhin zur Korrektur von Wellenfrontfehlern verwenden.

Gemäß einer weiteren erfindungsgemäßen Ausführungsform des Verfahrens umfasst der generierte Stellwegvektor zusätzlich Stellwege für mindestens einen weiteren optischen Manipulator der Projektionsbelichtungsanlage, enthält der ermittelte Korrekturwertvektor Korrekturwerte für die Stellwege des weiteren Manipulators, und erfolgt ein Einstellen des weiteren Manipulators mit Hilfe des korrigierten Stellwegvektors. Somit wird bei einer Korrektur von nicht vollständig ausführbaren Stellwegen für Zonen des optischen Manipulators auch die einstellbare optische Wirkung des mindestens einen weiteren optischen Manipulators berücksichtigt.

Gemäß einer erfindungsgemäßen Ausführungsform der Projektionsbelichtungsanlage ist ein Speicher zum Speichern einer Vielzahl von Korrekturwertvektoren für die Korrektureinrichtung vorgesehen. Die Beschaffung eines Korrekturwertvektors durch die Korrektureinrichtung lässt sich durch Zugriff auf die gespeicherten Korrekturwertvektoren schnell durchführen und ermöglicht ein Korrigieren des generierten Stellwegvektors während des Betriebs.

Gemäß einer weiteren erfindungsgemäßen Ausführungsform der Projektionsbelichtungsanlage ist die Korrektureinrichtung zum Ermitteln eines Basiskorrekturvektors mit Basisstellwegen auf Grundlage des Einschränkungsparameters, zum Ermitteln eines Skalierungsfaktors auf Grundlage des generierten Stellwegvektors und zum Berechnen des Korrekturwertvektors durch Skalieren des Basiskorrekturvektors mit dem ermittelten Skalierungsfaktor ausgebildet. Die nach Vorgabe durch den Einschränkungsparameter für einen nicht vollständig ausführbaren Stellweg ermittelte Basiskorrektur lässt sich durch Skalieren mit dem Skalierungsfaktor auch für viele andere nicht vollständig durchführbare Stellwege zur Korrektur des generierten Stellwegvektors verwenden. Entsprechend zum korrespondierenden Verfahrensanspruch wird durch die Verwendung eines Basiskorrekturvektors die Beschaffung von Korrekturwertvektoren für eine Vielzahl von generierten Stellwegvektoren wesentlich vereinfacht.

Ferner ist bei einer erfindungsgemäßen Ausführungsform der Projektionsbelichtungsanlage ein Speicher zum Speichern einer Vielzahl von Basiskorrekturvektoren für die Korrektureinrichtung vorgesehen. Für verschiedene Zonen und unterschiedliche stellwegeinschränkende Störungen ermittelte Basiskorrekturvektoren können in dem Speicher gespeichert und für die Korrektureinrichtung bereitgestellt werden. Hierdurch wird das Ermitteln eines Basiskorrekturvektors durch die Korrektureinheit beschleunigt und vereinfacht.

Die bezüglich der vorstehend aufgeführten Ausführungsformen, Ausführungsbeispiele bzw. Ausführungsvarianten, etc. des erfindungsgemäßen Verfahrens angegebenen Merkmale können entsprechend auf die erfindungsgemäße Projektionsbelichtungsanlage übertragen werden. Umgekehrt können die bezüglich der vorstehend ausgeführten Ausführungsformen, Ausführungsbeispiele bzw. Ausführungsvarianten der erfindungsgemäßen Projektionsbelichtungsanlage angegebenen Merkmale entsprechend auf das erfindungsgemäße Verfahren übertragen werden. Diese und andere Merkmale der erfindungsgemäßen Ausführungsformen werden in der Figurenbeschreibung und den Ansprüchen erläutert. Die einzelnen Merkmale können entweder separat oder in Kombination als Ausführungsformen der Erfindung verwirklicht werden. Weiterhin können sie vorteilhafte Ausführungsformen beschreiben, die selbstständig schutzfähig sind und deren Schutz ggf. erst während oder nach Anhängigkeit der Anmeldung beansprucht wird.

Kurzbeschreibung der Zeichnungen

Die vorstehenden, sowie weitere vorteilhafte Merkmale der Erfindung werden in der nachfolgenden detaillierten Beschreibung beispielhafter erfindungsgemäßer Ausführungsformen unter Bezugnahme auf die beigefügten schematischen Zeichnungen veranschaulicht. Es zeigt:

Fig. 1   ein Ausführungsbeispiel der erfindungsgemäßen Projektionsbelichtungsanlage für die Mikrolithographie in einer schematischen Ansicht,

Fig. 2   ein erstes Ausführungsbeispiel eines optischen Manipulators der Projektionsbelichtungsanlage nach Fig. 1 mit einem deformierbaren Spiegel in einem schematischen Querschnitt,

Fig. 3   den optischen Manipulator mit einem deformierbaren Spiegel gemäß Fig. 2 in einem schematischen Querschnitt entlang der Linie A-A in Fig. 2,

Fig. 4   ein zweites Ausführungsbeispiel eines optischen Manipulators der Projektionsbelichtungsanlage nach Fig. 1 mit einem deformierbaren Spiegel in einem schematischen Querschnitt,

Fig. 5   einen Aktuator des optischen Manipulators nach Fig 4 in einer schematischen Ansicht,

Fig. 6   den optischen Manipulator mit einem deformierbaren Spiegel gemäß Fig. 4 in einem schematischen Querschnitt entlang der Linie A-A in Fig. 4,

Fig. 7   ein drittes Ausführungsbeispiel eines optischen Manipulators der Projektionsbelichtungsanlage nach Fig. 1 mit einem deformierbaren Spiegel in einem schematischen Querschnitt,

Fig. 8   ein Substrat des deformierbaren Spiegels gemäß Fig. 7 mit elektrischen Zuleitungen in einer schematischen Ansicht,

Fig. 9   eine Bestrahlungseinrichtung eines durch IR-Strahlung beheizten thermischen Manipulators der Projektionsbelichtungsanlage nach Fig. 1 in einer schematischen Ansicht,

Fig. 10   eine schematische Ansicht der Bestrahlung einer Linse durch die Bestrahlungseinrichtung nach Fig. 9 zur Erzeugung einer Temperaturverteilung mit unterschiedlichen Temperaturen in verschiedenen lokalen Bereichen der Linse,

Fig. 11   eine optische Platte eines strombeheizten optischen Manipulators für ein Projektionsobjektiv der Projektionsbelichtungsanlage nach Fig. 1 in einer schematischen Ansicht,

Fig. 12   ein Flussdiagramm zur Veranschaulichung eines ersten Ausführungsbeispiels des erfindungsgemäßen Verfahrens, sowie

Fig. 13   ein Flussdiagramm zur Veranschaulichung eines zweiten Ausführungsbeispiels des erfindungsgemäßen Verfahrens.

Detaillierte Beschreibung erfindungsgemäßer Ausführungsbeispiele

In den nachstehend beschriebenen Ausführungsbeispielen bzw. Ausführungsformen oder Ausführungsvarianten sind funktionell oder strukturell einander ähnliche Elemente soweit wie möglich mit den gleichen oder ähnlichen Bezugszeichen versehen. Daher sollte zum Verständnis der Merkmale der einzelnen Elemente eines bestimmten Ausführungsbeispiels auf die Beschreibung anderer Ausführungsbeispiele oder die allgemeine Beschreibung der Erfindung Bezug genommen werden. Zur Erleichterung der Beschreibung ist in einigen Zeichnungen ein kartesisches xyz-Koordinatensystem angegeben, aus dem sich die jeweilige Lagebeziehung der in den Figuren dargestellten Komponenten ergibt.

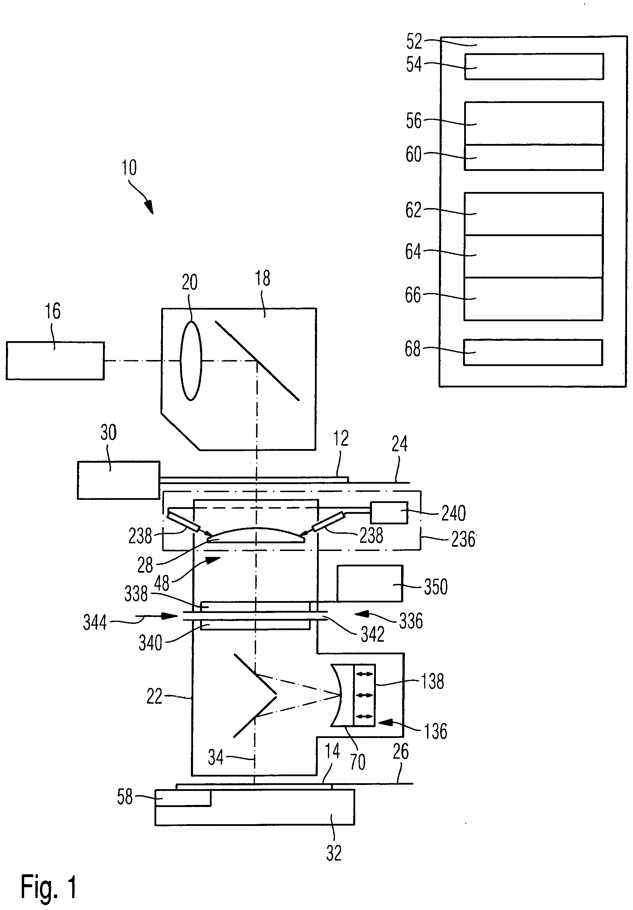

Fig. 1 stellt in einer schematischen Ansicht eine Projektionsbelichtungsanlage 10 für die Mikrolithographie zur Herstellung von mikrostrukturierten Bauelementen, z.B. integrierten Schaltkreisen, dar. Mit der Projektionsbelichtungsanlage 10 werden Strukturen einer Maske 12, auch Retikel genannt, auf eine fotosensitive Schicht eines Substrats 14 übertragen. Als Substrat werden in der Regel so genannte Wafer aus Silizium oder einem anderen Halbleitermaterial verwendet.

Die Projektionsbelichtungsanlage 10 enthält für diesen Zweck eine Strahlungsquelle 16 zur Erzeugung elektromagnetischer Strahlung. Als Strahlungsquelle 16 wird beispielsweise ein Laser oder dergleichen verwendet, der elektromagnetische Strahlung im UV-Bereich mit einer Wellenlänge von insbesondere etwa 365 nm, 248 nm oder 193 nm erzeugt. Alternativ kann die Strahlungsquelle 16 auch Strahlung mit kleinerer Wellenlänge erzeugen, z.B. Strahlung im extrem ultravioletten Wellenlängenbereich (EUV) mit einer Wellenlänge kleiner als 100 nm, insbesondere etwa 13,5 nm oder etwa 6,8 nm.

Die von der Lichtquelle 16 erzeugte elektromagnetische Strahlung 16, auch Belichtungsstrahlung bezeichnet, durchläuft zunächst ein Beleuchtungssystem 18 der Projektionsbelichtungsanlage 10. Das Beleuchtungssystem 18 enthält eine Vielzahl von optischen Elementen 20, beispielsweise Linsen oder Spiegel, von denen in Fig. 1 neben einem Umlenkspiegel nur eines symbolisch dargestellt ist. Das Beleuchtungssystem 18 dient zur Beleuchtung der Maske 12 mit einem geeigneten Beleuchtungsstrahl. Dazu formt das Beleuchtungssystem 18 die Strahlung mittels der optischen Elemente 20 derart, dass die gewünschten Eigenschaften hinsichtlich Form des Strahlquerschnitts, Form der Wellenfront, Polarisation und dergleichen aufweist. Beispielsweise enthält das Beleuchtungssystem einen Scannerschlitz zum kontinuierlichen Scannen der Maske 12 durch einen Beleuchtungsstrahl mit rechteckigem Querschnitt und ermöglicht eine Dipol-, Quadrupol- oder Multipol-Beleuchtung, wobei die einzelnen Punkte auf der Maske 12 jeweils aus unterschiedlichen Richtungen angestrahlt werden. Die Maske 12 ist in diesem Ausführungsbeispiel als Transmissionsmaske ausgebildet. Insbesondere für die EUV-Lithographie kann die Maske alternativ auch als Reflexionsmaske ausgeführt sein.

Ein Projektionsobjektiv 22 der Projektionsbelichtungsanlage 10 bildet die Strukturen der in einer Objektebene 24 des Projektionsobjektivs 22 angeordneten Maske 12 in eine Bildebene 26 ab, in der die fotosensitive Schicht des Substrats 14 positioniert ist. Hierfür enthält das Projektionsobjektiv 22 eine Vielzahl von einen Strahlengang 48 des Projektionsobjektivs definierenden optischen Elementen, welche abhängig vom Design des Projektionsobjektivs 22 und der Strahlungswellenlänge als Linsen, Spiegel oder dergleichen ausgeführt sind. In Fig. 1 werden exemplarisch ein optisches Element in Gestalt einer Linse 28 sowie ein optisches Element in Gestalt eines Spiegels 70 dargestellt.

Weiterhin enthält die Projektionsbeleuchtungsanlage 10 eine Positionierungsvorrichtung 30 zur Aufnahme und exakten Positionierung der Maske und eine Positionierungsvorrichtung 32 zur Fixierung, Bewegung und exakten Positionierung des Substrats 14. Die Positionierungsvorrichtung 30 für die Maske 12 ermöglicht auch während des Betriebs mit Hilfe von Aktuatoren eine räumliche Verschiebung, Drehung oder Neigung der Maske 12. Auch kann die Positionierungsvorrichtung 30 für einen Scan-Betrieb zum Verfahren der Maske 12 senkrecht zu einer optischen Achse 34 des Projektionsobjektivs 22 ausgebildet sein.

Entsprechend ist auch die Positionierungsvorrichtung 32 für das Substrat 14 mittels Aktuatoren zur räumlichen Verschiebung, Drehung oder Neigung des Substrats 14 während des Betriebs ausgebildet. Weiterhin ermöglicht die Positionierungsvorrichtung 32 ein Verfahren des Substrats 14 senkrecht zur optischen Achse 34 für einen Stepper- oder Scanner-Betrieb.

Bei der Abbildung der Strukturen der Maske 12 auf das Substrat 14 sollen Abbildungsfehler des Projektionsobjektivs 22 möglichst klein gehalten werden. Neben Abbildungsfehlern infolge von Fertigungs- und Montagetoleranzen können auch erst während eines Betriebes der Projektionsbelichtungsanlage 10 Abbildungsfehler im Projektionsobjektiv 22 auftreten. So kann es bei Linsen 28 an Orten, die über längere Zeit einer besonders hohen Lichtintensität ausgesetzt sind, zum Auftreten von Alterungseffekten, beispielsweise zu einer Verdichtung (engl. compaction) oder einer Verringerung der Dichte (engl. rarefaction) des Materials und somit zu einer lokal begrenzten Formänderung kommen.

Eine weitere Ursache für betriebsbedingte Abbildungsfehler ist eine lokale Erwärmung einzelner optischer Elemente, wie etwa von Linsen 28, durch eine unvermeidbare Absorption eines Anteils der durchtretenden elektromagnetischen Strahlung. Hierdurch können lokale Änderungen der Oberflächengeometrie durch Ausdehnung oder mechanische Spannung auftreten. Auch kann es zu einer Änderung der Materialeigenschaften, wie dem Brechungsindex, kommen. Abbildungsfehler von Objektiven werden häufig als Abweichung einer gemessenen realen optischen Wellenfront von einer idealen optischen Wellenfront beschrieben. Die Abweichung wird auch als Wellenfrontdeformation oder Wellenfrontfehler bezeichnet und lässt sich durch eine Reihenentwicklung in einzelne Anteile zerlegen. Eine Zerlegung nach Zernike-Polynome hat sich dabei als besonders geeignet erwiesen, da die einzelnen Terme der Zerlegung jeweils bestimmten Abbildungsfehlern wie beispielsweise Astigmatismus oder Koma zugeordnet werden können. Eine Definition der Zernike-Funktionen wird z.B. in US 2011/0216303 A1 dargestellt.

Das Projektionsobjektiv 22 enthält zur Kompensation von solchen während des Betriebs auftretenden oder sich ändernden Wellenfrontfehlern mindestens einen optischen Manipulator 136, 236 bzw. 336 mit einer Vielzahl von über einen Querschnitt des Strahlengangs 48 verteilten Zonen mit separat einstellbarer optischer Wirkung. Zu Veranschaulichungszwecken sind in dem Projektionsobjektiv 22 exemplarisch ein optischer Manipulator 136 mit einem deformierbaren Spiegel 70, ein durch Infrarotlichtbestrahlung beheizter thermischer Manipulator 236 und ein strombeheizter thermischer Manipulator 336 vorgesehen. In alternativen Ausführungen können sowohl eine andere Anzahl von optischen Manipulatoren als auch andersartig aufgebaute Manipulatoren mit einer Vielzahl von in ihrer optischen Wirkung individuell einstellbaren Zonen verwendet werden.

Der optische Manipulator 136 umfasst den deformierbaren Spiegel 70 sowie eine Manipulationseinrichtung 138. Der optische Manipulator 136 kann in einer Feld- oder Pupillenebene des Projektionsobjektivs 22 oder intermediär, d.h. zwischen Feld- und Pupillenebene, angeordnet werden. Der Spiegel 70 des optischen Manipulators 136 ist als adaptiver Spiegel mit einer Vielzahl von separat deformierbaren Bereichen einer reflektierenden Beschichtung als individuell in ihrer optischen Wirkung einstellbare Zonen ausgebildet. Eine Deformierung einer Zone erfolgt durch die Manipulationseinrichtung 138. Ein optischer Manipulator 136 mit einem solchen Spiegel eignet sich insbesondere für eine elektromagnetische Belichtungsstrahlung im EUV-Spektralbereich.

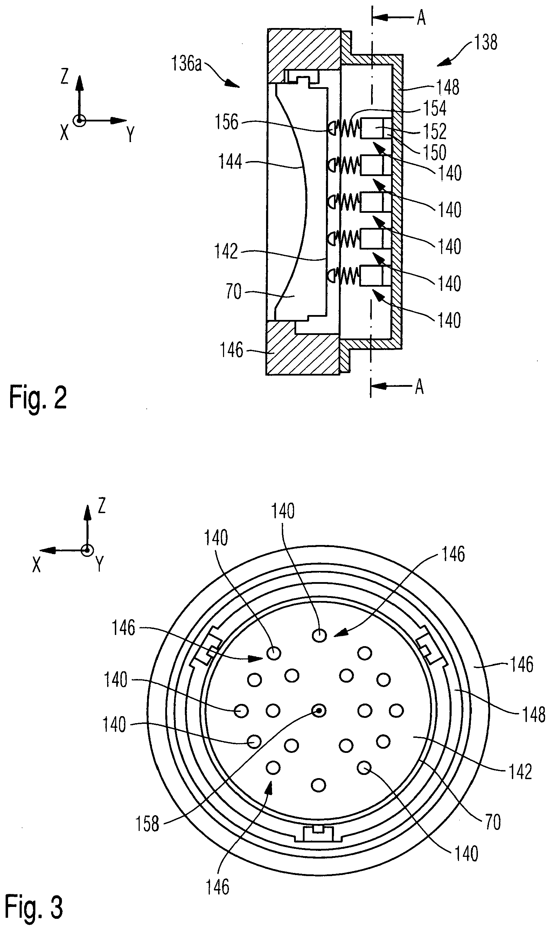

In Fig. 2 wird ein erstes Ausführungsbeispiel 136a des optischen Manipulators 136 mit einem deformierbaren konkaven Spiegel 70 und Aktuatoren 140 dargestellt, welche senkrecht (in -Y-Richtung) gegen die Rückseite 142 des Spiegels 70 einwirken. Ein solcher optischer Manipulator 136 wird z.B. in der JP 2013-161992 A beschrieben. Der Spiegel 70 weist eine reflektierende Beschichtung 144 an seiner Vorderseite auf und wird von einer Spiegelhaltung 145 fixiert. Der Manipulator 136 enthält weiterhin eine Manipulationseinrichtung 138 mit einem Gehäuse 148 und einer Vielzahl von daran befestigten Aktuatoren 140. Jeder Aktuator 140 verfügt über einen Drucksensor 150, ein Antriebselement 152, eine Feder 154 und ein Kontaktelement 156. Das Antriebselement 152 ist in Y-Richtung expandierbar und zusammenziehbar ausgebildet und kann für diesen Zweck beispielsweise ein piezoelektrisches Element oder einen Ultraschallmotor aufweisen. Je nach Ausdehnung des Antriebselements 152 wirkt über die Feder 154 und das Kontaktelement 156 eine entsprechende Kraft im Kontaktbereich auf die Rückseite 142 des Spiegels 70. Hierdurch erfolgt eine lokale Deformation der reflektierenden Beschichtung 144. Die einwirkende Kraft wird von dem Drucksensor 150 erfasst und kann von einer nicht dargestellten Steuerung zum Einstellen einer vorgegebenen Deformation verarbeitet werden.

Fig. 3 zeigt einen Querschnitt des optischen Manipulators 136a entlang der Linie A-A in Fig. 2. Die Aktuatoren 140 sind symmetrisch zur optischen Achse 158 des Spiegels 70 an dessen Rückseite 142 angeordnet. Jeder Aktuator 140 lässt sich einzeln ansteuern und verursacht an seinem Druckbereich eine lokale Verformung des Spiegels 70. Diese Druckbereiche stellen somit individuell in ihrer optischen Wirkung einstellbare Zonen 146 des optischen Manipulators 136a dar.

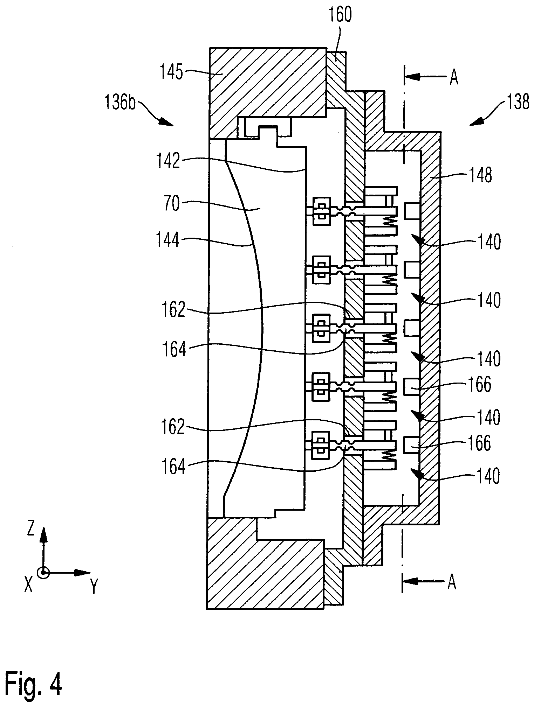

In Fig. 4 wird ein zweites Ausführungsbeispiel 136b des optischen Manipulators 136 mit einem deformierbaren konkaven Spiegel 70 dargestellt, wie es beispielsweise in der JP 2013-106014 offenbart wird. Der Spiegel 70 wird von einer Spiegelhalterung 145 fixiert und verfügt an seiner Vorderseite über eine reflektierende Beschichtung 144. Weiterhin enthält der optische Manipulator 136b eine Manipulationseinrichtung 138 mit einer Vielzahl von Aktuatoren 140. Die Aktuatoren 140 sind an einer Trägerplatte 160 befestigt und wirken auf Spiegelpfosten 164 ein, welche an der Rückseite 142 des Spiegels 70 befestigt sind und sich in Y-Richtung durch Ausnehmungen 162 in der Trägerplatte 160 erstrecken. Im Gegensatz zum Ausführungsbeispiel nach Fig. 2 üben die Aktuatoren 140 eine Kraft in X- und Z-Richtung, d.h. parallel zur Rückseite 142 des Spiegels 70, und somit seitlich auf die Spiegelpfosten 164 aus und bewirken so eine lokale Deformation der reflektierenden Beschichtung 144 des Spiegels 70. Weiterhin enthält der optische Manipulator 136b ein Gehäuse 148, an dem Positionssensoren 166 zur Bestimmung der X-Z-Auslenkung der Spiegelpfosten 164 angeordnet sind.

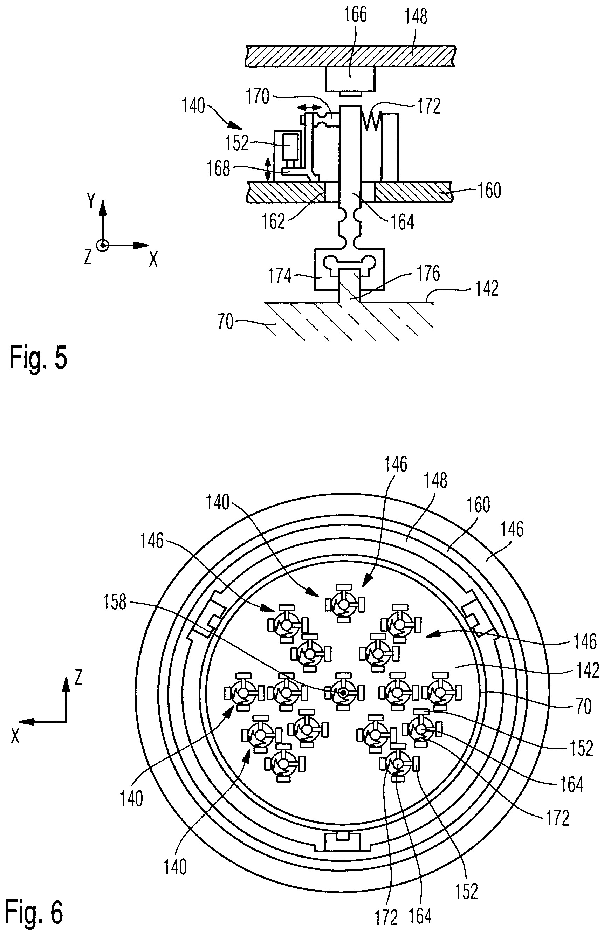

Fig. 5 zeigt einen Aktuator 140 des optischen Manipulators 136 nach Fig 4 in einer detaillierten schematischen Ansicht. Der Aktuator 140 enthält ein Antriebselement 152. Das Antriebselement 152 ist an der Trägerplatte 160 befestigt und kann sich in Y-Richtung ausdehnen oder zusammenziehen. Ein sich dabei bewegendes Ende des Antriebselements 152 wirkt auf einen Arm eines L-förmigen Hebels 168 ein, welcher schwenkbar an der Trägerplatte 160 befestigt ist. Ein anderer Arm des Hebels 168 bewegt sich dadurch bei diesem Aktuator 140 in X-Richtung und wirkt über ein Verbindungselement 170 auf den Spiegelpfosten 164 ein. Der Spiegelpfosten 164 ist durch eine Feder 172 vorgespannt und erstreckt sich durch die Ausnehmung in Richtung Spiegel 70. Mit einem Befestigungselement 174 ist der Spiegelpfosten 164 an einem aus der Rückseite 142 hervorstehenden Teil 176 des Spiegels 70 befestigt. Für eine Auslenkung des Spiegelpfostens 164 in Z-Richtung enthält der Aktuator 140 ein weiteres Antriebselement, einen entsprechend angeordneten Hebel mit einem Verbindungselement und eine weitere Feder.

Fig. 6 zeigt einen Querschnitt des optischen Manipulators 136b gemäß Fig. 4 entlang der Linie AA in Fig. 4. Deutlich zu erkennen ist, dass jeder Aktuatoren 140 jeweils eine Feder 172 und ein Antriebselement 152 für eine Auslenkung des Spiegelpfostens 164 in X-Richtung und in Z-Richtung aufweist. Die Aktuatoren sind teilweise symmetrisch zur optischen Achse 158 des Spiegels 70 an dessen Rückseite 142 angeordnet. Jeder Aktuator 140 lässt sich einzeln ansteuern und verursacht eine lokale Verformung der reflektiven Beschichtung 144 des Spiegels 70. Diese lokalen Bereiche bei den Aktuatoren 140 stellen separat in ihrer optischen Wirkung einstellbare Zonen 146 des optischen Manipulators 136b dar.

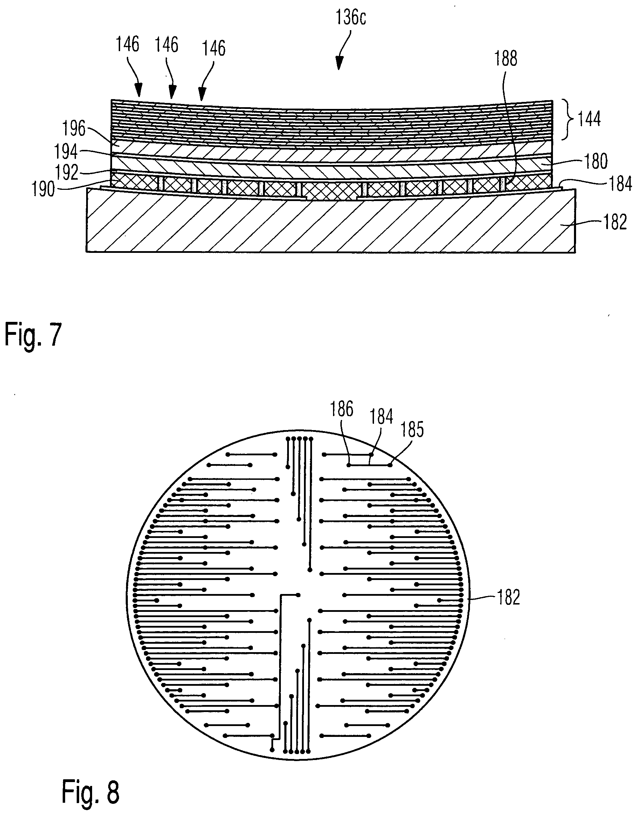

In Fig. 7 wird ein drittes Ausführungsbeispiel 136c eines optischen Manipulators 136 mit einem deformierbaren konkaven Spiegel 70 in einem schematischen Querschnitt dargestellt. Der optische Manipulator 136c enthält unter einer reflektierenden Beschichtung 144 eine piezoelektrische Schicht 180, mit der durch lokales Anlegen einer elektrischen Spannung eine lokale Deformation der reflektierenden Beschichtung 144 bewirkt werden kann. Ein solcher optischer Manipulator 136c wird z.B. in der DE 10 2011 081 603 A1 beschrieben.

Der optische Manipulator 136c umfasst ein konkav ausgeformtes Substrat 182, auf dem eine Vielzahl von elektrischen Leitungen 184 angeordnet ist. Fig. 8 zeigt in einer Draufsicht eine beispielhafte Anordnung der elektrischen Leitungen 184 auf dem Substrat 182. Jede elektrische Leitung 184 enthält eine erste Kontaktfläche 185 in unmittelbarer Nähe des Umfangs des Substrats 182. Weiterhin enthält jede elektrische Leitung 184 eine zweite Kontaktfläche 186, die bei einer Durchkontaktierung in einer über den elektrischen Leitungen 184 vorgesehenen Isolationsschicht 190 angeordnet ist. Die Isolationsschicht 190 trägt eine Schicht aus flächig ausgebildeten Steuerelektroden 192, welche jeweils über eine Durchkontaktierung 188 elektrisch mit der entsprechenden elektrischen Leitung 184 verbunden sind. Auf den Steuerelektroden 192 ist die piezoelektrische Schicht 180 angeordnet, welche ihrerseits eine Gegenelektrode 194 trägt. Die Gegenelektrode 194 erstreckt sich über die gesamte piezoelektrische Schicht 180 und trägt eine Schutzschicht 196. Auf der Schutzschicht 196 ist schließlich die reflektierende Beschichtung 144 angeordnet. Durch Anlegen einer entsprechenden Spannung zwischen einer ersten Kontaktfläche 185 und der Gegenelektrode 194 wird eine lokale Verformung der piezoelektrischen Schicht 180 im Bereich der zugehörigen Steuerelektrode 192 erzielt. Die lokalen Bereiche der reflektierenden Beschichtung 144 bei jeder der Steuerelektroden 192 stellen somit individuell in ihrer optischen Wirkung einstellbare Zonen 146 des optischen Manipulators 136c dar. Im Fall eines Kurzschlusses zweier benachbarter Steuerelektroden 192 erfolgt eine fehlerhafte Gleichschaltung der Steuersignale der zugehörigen Zonen 146. In diesem Fall lässt sich nur ein einheitlicher Stellweg für die betroffenen Zonen 146 einstellen.

Der in Fig. 1 dargestellte thermische Manipulator 236 mit einer Infrarotlichtbestrahlung von lokalen Bereichen der Linse 28 umfasst eine Vielzahl von Bestrahlungseinheiten 238, welche von einer Infrarotlichtquelle 240 bereitgestelltes infrarotes Licht jeweils mit einer einstellbaren Intensität auf einen bestimmten Bereich bzw. eine Zone der Linse 28 einstrahlen. Der thermische Manipulator 236 kann in einer Feld- oder Pupillenebene des Projektionsobjektivs 22 oder intermediär, d.h. zwischen Feld- und Pupillenebene, angeordnet werden. Ein thermischer Manipulator 236, der Infrarotlicht auf einen bestimmten Bereich bzw. eine Zone der Linse 28 einstrahlt, eignet sich insbesondere für eine elektromagnetische Belichtungsstrahlung im tiefen ultravioletten Spektralbereich (DUV) oder im VUV-Spektralbereich.

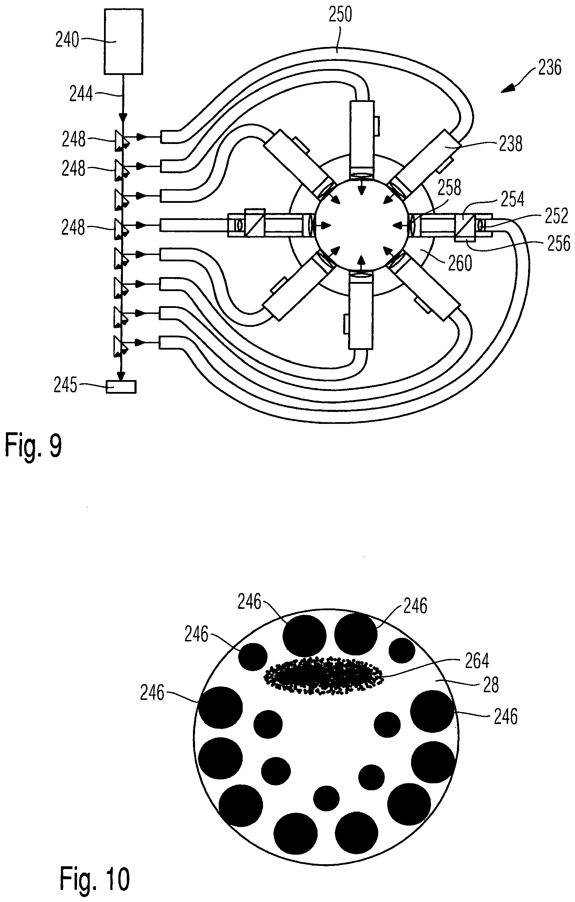

In Fig. 9 wird eine Ausführungsform eines solchen thermischen Manipulators 236 schematisch dargestellt, wie sie z.B. in der US 2008/0204682 A1 offenbart wird. Die Infrarotlichtquelle 240 erzeugt als Heizstrahlung Infrarotstrahlung 244. Die IR-Strahlung 244 breitet sich in Richtung eines fotoelektronischen Sensors 245 aus. In diesem Strahlengang ist hintereinander eine Vielzahl von schwenkbaren Umlenkspiegeln 248 angeordnet. In einer ersten Drehposition befindet sich ein jeweiliger der schwenkbaren Umlenkspiegel 248 außerhalb des Strahlengangs der IR-Strahlung 244 und lässt diese in Richtung des fotoelektrischen Sensors 245 passieren. In einer zweiten Drehposition lenkt jeder der Umlenkspiegel 248 die IR-Strahlung 244 derart um, dass diese in einen jeweiligen Lichtwellenleiter 250 eingekoppelt wird. Durch den Lichtwellenleiter 250 wird die IR-Strahlung 244 zu einer Bestrahlungseinheit 238 geführt. Für jede Bestrahlungseinheit 238 ist ein Umlenkspiegel 248 und ein Lichtwellenleiter 250 vorgesehen.

In einer Bestrahlungseinheit 238 durchläuft die IR-Strahlung 244 nach Austritt aus dem Lichtwellenleiter 250 zunächst eine erste Kondensorlinse 252 und anschließend einen Strahlteiler 254. Der Strahlteiler 254 lenkt einen geringen Anteil der IR-Strahlung 244 auf einen fotoelektrischen Sensor 256. Der weitaus größere Anteil der IR-Strahlung 244 tritt durch eine zweite Kondensorlinse 258 aus der Bestrahlungseinheit 238 aus und bestrahlt einen bestimmten Bereich der Linse 28. Dazu werden alle Bestrahlungseinheiten 238 von einer geeignet ausgebildeten Halterung 260 entsprechend ausgerichtet gehalten. Die Intensität der Bestrahlung und somit die Temperaturerhöhung ist für jeden Bereich bzw. jede Zone auf der Linse 28 direkt von der Dauer und Häufigkeit abhängig, mit der der jeweilige Umlenkspiegel 248 die IR-Strahlung 244 in den entsprechenden Lichtwellenleiter 250 einkoppelt. Die Intensität der IR-Strahlung lässt sich durch die fotoelektrischen Sensoren 256 für jede Zone erfassen.

Fig. 10 zeigt eine schematische Ansicht der Bestrahlung der Linse 28 durch die Bestrahlungseinheiten 238 gemäß Fig. 9 zur Erzeugung einer Temperaturverteilung mit unterschiedlichen Temperaturen in verschiedenen lokalen Zonen 246 der Linse 28. Große Kreise symbolisieren eine hohe Intensität der Bestrahlung und kleinere Kreise eine geringere Intensität. Ebenfalls dargestellt ist ein beispielhafter Querschnitt 264 des Belichtungsstrahlengangs 48, welcher im dargestellten Fall asymmetrisch ist. Auch die Belichtungsstrahlung führt zu einer, in diesem Fall unerwünschten, Temperaturerhöhung im Bereich des Querschnitts 264. Durch eine Temperaturerhöhung verändern sich temperaturabhängige optische Eigenschaften des Linsenmaterials, wie beispielsweise der Brechungsindex. Durch eine geeignete Bestrahlung der Linse 28 mit den Bestrahlungseinheiten 238 lassen sich durch die Belichtungsstrahlung induzierte Veränderungen der optischen Eigenschaften der Linse 28 kompensieren.

Der in Fig. 1 dargestellte optische Manipulator 336 ist gemäß einem Ausführungsbeispiel als strombeheizter bzw. strombetriebener thermischer Manipulator ausgebildet und enthält als optische Elemente eine transparente erste optische Platte 338 und eine transparente zweite optische Platte 340. Die optischen Platten 338, 340 sind senkrecht zur optischen Achse 34 im Strahlengang des Projektionsobjektivs 22 angeordnet und lassen sich jeweils lokal über sehr kleine elektrisch leitende und ohmsche Strukturen beheizen. Zwischen den optischen Platten 338, 340 ist ein Spalt 342 ausgebildet, durch den zur Kühlung eine Luftströmung 344 geführt wird.

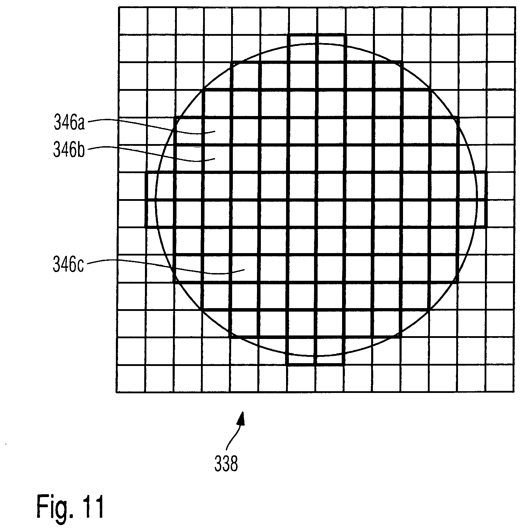

Fig. 11 zeigt die erste optische Platte 338 in einer schematischen Ansicht. Die Platte 338 enthält eine zweidimensionale Matrix aus separat beheizbaren Zonen 346. In diesem Ausführungsbeispiel weist die erste optische Platte 338 eine 14x14-Matrix von Zonen 346 auf. Dabei sind sechsundneunzig separat beheizbare Zonen 346 optisch wirksam im Strahlengang 48 des Projektionsobjektivs 22 angeordnet. Die zweite optische Platte 340 ist entsprechend ausgebildet, so dass der optische Manipulator 336 insgesamt hundertzweiundneunzig beheizbare Zonen 346 im Strahlengang 48 aufweist. Alternativ ist auch eine andere Anzahl, Anordnung und Form der Zonen 346 möglich, z.B. können die Zonen radial angeordnet oder als Streifen oder kreisbogenförmig ausgebildet sein. Gemäß weiteren Ausführungsbeispielen weist die erste optische Platte 338 eine Matrix mit mindestens 5x5 Zonen, insbesondere eine Matrix mit mindestens 10x10 Zonen, beispielsweise eine Matrix mit 10x10 Zonen oder eine Matrix mit 21x21 Zonen auf.

Eine Beheizung der Zonen 346 erfolgt stets so, dass sich gegenüber der Umgebungstemperatur kältere und wärmere Bereiche insgesamt ausgleichen. Zusätzlich werden Zonen 346 am Rand der optischen Platten 338, 340 mit thermischem Kontakt zu anderen Komponenten der Projektionsobjektivs 22 aktiv auf Umgebungstemperatur beheizt. Auf diese Weise wird eine thermische Neutralität des optischen Manipulators 336 gewährleistet.

Die optischen Platten 338, 340 des optischen Manipulators 336 sind in diesem Ausführungsbeispiel als planparallele Quarzplatten ausgebildet. Alternativ kann der optische Manipulator z.B. nur eine optische Platte, mehr als zwei optische Platten, nicht planparallele Platten oder eine oder mehrere Linsen oder dergleichen mit einer Vielzahl von beheizbaren Zonen enthalten.

In Quarz führt bei einer Wellenlänge von 193 nm eine Temperaturerhöhung zu einer Erhöhung des Brechungsindex. Dieser Effekt ist u.a. die Ursache für Wellenfrontfehler durch Linsenaufheizung (engl. Lens Heating). Bei dem optischen Manipulator 336 wird dieser Effekt zur Erzeugung einer Wellenfrontdeformation verwendet, welche einen momentan auftretenden Wellenfrontfehler in dem Projektionsobjektiv 22 kompensiert. Durch die hohe Anzahl von Zonen 346 lässt sich der optische Manipulator 336 sehr flexibel zur Kompensation einer Vielzahl verschiedener, während des Betriebs auftretender oder sich ändernder Wellenfrontfehler verwenden.

In der nachfolgenden Beschreibung wird sowohl auf Fig. 1 als auch auf Fig. 11 Bezug genommen. Die nachfolgend in Bezug auf den optischen Manipulator 336 vorgenommene Beschreibung des Betriebs des Manipulators kann in den meisten Teilen analog auf den optischen Manipulator 136 mit einem deformierbaren Spiegel oder den optischen Manipulator 236 mit einer Infrarotbeheizung übertragen werden. Der optische Manipulator 336 enthält weiterhin eine Aktuierungseinrichtung 350 zum Einstellen eines vorgegebenen Temperaturprofils für beide optische Platten 338, 340. Ein solches Temperaturprofil gibt für jede Zone 346 beider optischer Platten 338, 340 Temperaturwerte oder entsprechende Werte, wie etwa eine Heizleistung in W/m$^2$ als Stellweg vor. Die Temperaturprofile stellen somit Stellwegvektoren dar. Die Aktuierungseinrichtung 350 versorgt jede Zone 346 des optischen Manipulators 336 mit einem entsprechenden Heizstrom zur Einstellung des vorgegebenen Stellwegvektors und kann zusätzlich die Kühlung durch die Luftströmung 344 regeln.

Die Projektionsbelichtungsanlage 10 enthält weiterhin eine Manipulatorsteuerung 52 zum Steuern eines oder mehrerer der optischen Manipulatoren 136, 236 und 336 für eine Kompensation von während des Betriebs auftretenden oder sich ändernden Wellenfrontfehlern. Die Manipulatorsteuerung 52 umfasst ein Bestimmungsmodul 54 für momentan vorliegende Wellenfrontfehler und einen Stellweggenerator 56 zum Generieren eines zur Korrektur des vorliegenden Wellenfrontfehlers geeigneten Stellwegvektors. Der generierte Stellwegwegvektor kann neben Stellwegen für einen oder mehrere der in Fig. 1 dargestellten optischen Manipulatoren 136, 236 und 336 auch Stellwege für andere Manipulatoren der Projektionsbelichtungsanlage 10 enthalten, z.B. auch für nicht in Fig. 1 dargestellte Positionierungseinrichtungen oder Deformationseinrichtungen optischer Elemente 28 des Projektionsobjektivs 22. Nachstehend wird die Generierung eines Stellwegvektors am Beispiel des optischen Manipulators 336 unter Bezugnahme auf die in Fig. 11 dargestellte optische Platte 338 beschrieben. Das beschriebene Prinzip kann analog auf die Generierung eines Stellwegvektors für den optischen Manipulator 136, den optischen Manipulator 236 oder einen anderen optischen Manipulator übertragen werden.

Das Bestimmungsmodul 54 führt zur Bestimmung eines momentan vorliegenden Wellenfrontfehlers entweder eine Messung aus oder führt eine Extrapolation auf Grundlage zuvor gemessener Wellenfrontfehler und weiterer Parameter, wie z.B. Umgebungsdruck und dergleichen aus. Eine derartige Extrapolation kann darüber hinaus z.B. auf Grundlage zuvor gemessener Wellenfrontfehler sowie eines Modells, welches Lens-Heating bzw. Spiegelaufheizung vorhersagt, erfolgen. Die Messung eines Wellenfrontfehlers erfolgt inbesondere interferometrisch mit einem Wellenfrontsensor 58, welcher in die Positionierungsvorrichtung 32 integriert ist. Eine Vorrichtung zur interferometrischen Bestimmung von Wellenfronten wird z.B. in der US 2002/0001088 A1 beschrieben. Das Bestimmungsmodul 54 zerlegt einen gemessenen Wellenfrontfehler z.B. numerisch in Zernikepolynome bis zur Ordnung n = 64. Alternativ kann auch eine andere Ordnung, insbesondere 36, 49 oder 100, oder eine Zerlegung in ein anderes, vorzugsweise orthonormales Funktionensystem verwendet werden. Die Zernike-Koeffizienten oder entsprechende andere Koeffizienten eines gemessenen oder extrapolierten Wellenfrontfehlers werden anschließend für den Stellweggenerator 56 bereitgestellt.

Der Stellweggenerator 56 generiert gemäß einer Ausführungsform auf Grundlage der Zernike-Koeffizienten oder anderer geeigneter Parameter eines gemessenen oder extrapolierten Wellenfrontfehlers einen Stellwegvektor mit Stellwegen für jede Zone 346 des optischen Manipulators 336 und für weitere Manipulatoren der Projektionsbelichtungsanlage 10, wie etwa für jede Zone 146 des optischen Manipulators 136 oder für jede Zone 246 des optischen Manipulators 236. Der Stellwegvektor wird dabei vom Stellweggenerator derart konfiguriert, dass die Wellenfront des Projektionsobjektivs 22 an eine Sollwellenfront angenähert wird. Die Sollwellenfront kann gemäß einer Ausführungsform durch an den einzelnen Feldpunkten in der Bildebene 26 vorliegende sphärische Wellenfronten definiert sein, wobei die Einhüllende dieser Wellenfronten entlang der Bildebene 26 eine ebene Wellenfront ergibt. Eine derartige Sollwellenfront wird im Rahmen dieser Anmeldung als Referenzwellenfront bezeichnet. Die Annäherung der tatsächlichen Wellenfront an die Referenzwellenfront bedeutet eine Minimierung des Wellenfrontfehlers des Projektionsobjektivs 22.

Gemäß einer weiteren Ausführungsform ist die Sollwellenfront, an welche die Wellenfront des Projektionsobjektivs 22 unter Verwendung des Stellwegvektors angenähert wird, durch eine von der Referenzwellenfront gezielt abweichende Wellenfront definiert. Eine derartige gezielt abweichende Sollwellenfront kann mittels sogenannten Imaging-Enhancement-Verfahren bestimmt werden. Hierbei werden gezielt an die im Einzelfall abzubildenden Maskenstrukturen angepasste Wellenfrontabweichungen festgelegt, die es ermöglichen, die entsprechenden Maskenstrukturen mit höherer Auflösung abzubilden.

Die Generierung des Stellwegvektors erfolgt durch einen stellweggenerierenden Optimierungsalgorithmus der beispielsweise auf Basisfunktionen für jede Zone 346 mit einer 3x3-Matrix, 5x5-Matrix oder 7x7-Matrix zur Berücksichtigung einer Wärmeleitung in benachbarte Zonen 346 basiert. Der Optimierungsalgorithmus kann auf dem Fachmann bekannten Algorithmen, z.B. Singulärwertzerlegung (SVD) oder Tikhonov-Regularisierung, beruhen.

Die hohe Anzahl von Zernike-Koeffizienten, die hohe Anzahl von Stellwegen bzw. Manipulatorfreiheitsgraden und die dabei einzuhaltenden Randbedingungen, wie z.B. die thermische Neutralität des optischen Manipulators 336, führt zu einem sehr komplexen Optimierungsproblem, das für sich in der Regel nicht mehr in Echtzeit während des Belichtungsbetriebs der Projektionsbelichtungsanlage 10 gelöst werden kann. Daher werden in einem Speicher 60 des Stellweggenerators 56 zuvor ermittelte Stellwegvektoren für bestimmte Wellenfrontfehler, beispielsweise für bestimmte Zernike-Koeffizienten gespeichert. Diese werden bei einer Generierung eines Stellwegs von dem Optimierungsalgorithmus zur Lösung des Optimierungsproblems berücksichtigt. Auf diese Weise ist eine Stellweggenerierung durch den Stellweggenerator 56 in Echtzeit während des Belichtungsbetriebs der Projektionsbelichtungsanlage 10 möglich.

Die Projektionsbelichtungsanlage 10 enthält weiterhin eine Zonenprüfeinheit 62 zum Überprüfen der Funktionstüchtigkeit jeder Zone 346 des optischen Manipulators 336. Insbesondere prüft die Zonenprüfeinheit 62, ob bei jeder Zone 346 die Stellwege und damit die Temperatur innerhalb eines vorgegebenen Sollstellwertbereichs einstellbar sind. Eine Ursache für eine Stellwegeinschränkung bei den beheizbaren Zonen 346 kann eine fehlerhafte Gleichschaltung der Steuersignale zweier benachbarter Zonen 346a, 346b in Gestalt eines elektrischen Kurzschlusses zwischen den zwei benachbarten Zonen 346a, 346b sein. Hierdurch werden beide Zonen 346a, 346b stets mit der gleichen Heizleistung betrieben. Es lässt sich nur ein einheitlicher Stellweg für die Zonen 346a, 346b einstellen. Eine weitere Ursache für eine Stellwegeinschränkung kann eine während des Betriebs auftretende oder bereits vor Inbetriebnahme vorhandene fehlerhafte Widerstandscharakteristik einer Zone 346c sein. Die außerhalb der Toleranz liegende Widerstandscharakteristik kann insbesondere zu einem eingeschränkten Stellwegbereich führen.

Detektiert die Zonenprüfeinheit 62 einen Kurzschluss zwischen den Zonen 346a, 346b, gibt sie als Einschränkungsparameter für die kurzgeschlossenen Zonen 346a, 346b einen einheitlichen Stellweg vor. Das gilt analog bei dem unter Bezugnahme auf die in Fig. 7 dargestellte Ausführungsform beschriebenen Kurzschluss zweier benachbarter Steuerelektroden 192. Stellt die Zonenprüfeinheit 62 einen eingeschränkten Stellwegbereich auf Grund einer fehlerhaften Widerstandscharakteristik fest, gibt sie als Einschränkungsparameter für die fehlerhafte Zone 346b einen maximal zulässigen Stellweg vor. Im Fall des optischen Manipulators 136 kann die Zonenprüfeinheit 62 zu einer entsprechenden Prüfung der Aktuatorcharakteristik jeder Zone des deformierbaren Spiegels 70 ausgebildet sein. Auch kann die Zonenprüfeinheit 62 zu einer Prüfung der Aktuatorcharakteristik jeder Zone des optischen Manipulators 236 mit einer Infrarotbeheizung konfiguriert sein.

Stellwegeinschränkungen auf Grund von defekten Zonen 346a, 346b, 346c führen bei einem generierten Stellwegvektor mit einem nicht vollständig ausführbaren Stellweg für eine oder mehrere dieser Zonen 346a, 346b, 346c zu einer fehlerhaften Einstellung des optischen Manipulators 336 und somit zu einer mangelhaften Kompensation eines vorhandenen Wellenfrontfehlers. Es können auch neue Wellenfrontfehler induziert werden. Eine Anpassung des Optimierungsalgorithmus zur Stellweggenerierung an die Stellwegeinschränkungen wäre mit einem sehr großen Zeitaufwand verbunden. Der bei einer Anpassung des Optimierungsalgorithmus an die Stellwegeinschränkungen benötigte große Zeitaufwand ist insbesondere darin begründet, dass die vom Optimierungsalgorithmus genutzten, für bestimmte Wellenfrontfehler vorgegebenen Stellwegvektoren keine Gültigkeit mehr hätten und durch zeitaufwändige Lösung eines komplexen Optimierungsproblems komplett neu ermittelt werden müssten.

Eine Überprüfungseinrichtung 64 der Projektionsbelichtungsanlage 10 ermittelt daher zunächst, ob für eine oder mehrere Zonen 346 ein Einschränkungsparameter vorgegeben ist und überprüft anschließend bei jedem generierten Stellwegvektor die Stellwege für Zonen 346a, 346b, 346c mit vorgegebenem Einschränkungsparameter auf Durchführbarkeit. Stellt die Überprüfungseinrichtung 64 einen nicht ausführbaren Stellweg für eine oder mehrere der Zonen mit vorgegebener Einschränkung fest, wird eine entsprechende Korrektur des generierten Stellwegvektors ausgelöst. Beispiele für nicht vollständig ausführbare Stellwege sind etwa unterschiedliche Stellwege für die kurzgeschlossenen Zonen 346a, 346b oder ein über den eingeschränkten Stellwegbereich hinausgehender Stellweg für die fehlerhafte Zone 346c. Zusätzlich kann die Überprüfungseinrichtung 64 bei jedem generierten Stellwegvektor alle Stellwege für vollfunktionsfähige Zonen 346 auf Einhaltung des Sollstellwegbereichs überprüfen. Bei einem fehlerhaft generierten, über den Sollstellwegbereich hinausgehenden Stellweg wird ebenfalls eine Korrektur ausgelöst. Im Fall der Generierung eines Stellwegvektors für einen der optischen Manipulatoren 136 und 236 kann die Überprüfungseinrichtung 64 die bezüglich der Zonen 146 bzw. 246 geltenden Stellwege auf Einhaltung des entsprechenden Sollstellwegbereichs überprüfen. Die Zonenprüfeinheit 62 sowie die Überprüfungseinrichtung 64 können auch zu einer sogenannten Prüfeinrichtung zusammengefasst sein.

Die Projektionsbelichtungsanlage 10 enthält ferner eine Korrektureinrichtung 66 zum Korrigieren des generierten Stellwegvektors bei Vorliegen eines oder mehrerer nicht vollständig ausführbarer Stellwege. Die Korrektureinrichtung 66 prüft zunächst, ob in einem Speicher 68 bereits ein Korrekturwertvektor für den oder die nicht ausführbaren Stellwege vorliegt. Falls einer vorliegt, wird dieser für die Korrektur des generierten Stellwegvektors verwendet.

Andernfalls oder alternativ prüft die Korrektureinrichtung 66, ob in dem Speicher 68 ein Basiskorrekturvektor für die durch den Einschränkungsparameter vorgegebene Einschränkung und die Zone bzw. Zonen vorliegt. Der Basiskorrekturvektor stellt einen Korrekturwertvektor für eine Basisstörung bezüglich der Zone bzw. Zonen und der vorliegenden Einschränkung dar. Falls ein Basiskorrekturvektor vorliegt, ermittelt die Korrektureinrichtung 66 einen geeigneten Skalierungsfaktor auf Grundlage des generierten Stellwegvektors, insbesondere des oder der nicht ausführbaren Stellwege. Anschließend berechnet die Korrektureinrichtung 66 durch Skalieren des Basiskorrekturvektors mit dem ermittelten Skalierungsfaktor den Korrekturwertvektor. Zusätzlich kann die Korrektureinrichtung zum Berechnen eines Basiskorrekturvektors ausgebildet sein.

Sowohl der Korrekturwertvektor als auch der Basiskorrekturvektor enthalten Werte für alle Stellwege des generierten Stellwegvektors. Durch Addieren des jeweiligen Korrekturwerts des Korrekturwertvektors zum entsprechenden Stellweg des generierten Stellwegvektors erzeugt die Korrektureinrichtung 66 einen korrigierten Stellwegvektor.

Die Aktuierungseinrichtung 50 stellt anschließend die Heizleistung für alle Zonen 346 des optischen Manipulators 336 entsprechend den Stellwegen des korrigierten Stellwertvektors ein. Auf diese Weise wird bei dem optischen Manipulator 336 trotz einer oder mehrerer defekter Zonen die von dem generierten Stellwegvektor vorgegebene optische Wirkung eingestellt. Auch bei den anderen Manipulatoren der Projektionsbelichtungsanlage 10, wie etwa dem optischen Manipulator 136 oder dem optischen Manipulator 236, erfolgt eine Einstellung gemäß entsprechender Stellwege des korrigierten Stellwegvektors.

Eine weitere Beschreibung der Funktionsweise und des Zusammenwirkens der Komponenten der Projektionsbelichtungsanlage 10 und insbesondere auch der Berechnung der Basiskorrekturvektoren und der Skalierungsfaktoren erfolgt nachfolgend zusammen mit der Beschreibung zweier Ausführungsbeispiele des Verfahrens zum Steuern einer Projektionsbelichtungsanlage.

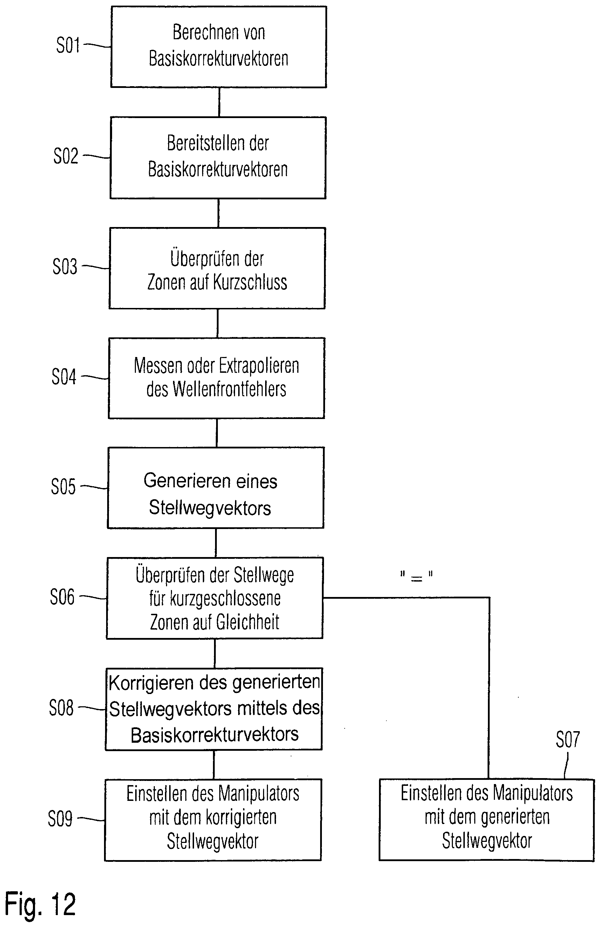

In Fig. 12 wird ein Flussdiagramm zur Veranschaulichung eines ersten Ausführungsbeispiels des Verfahrens zum Steuern der Projektionsbelichtungsanlage 10 dargestellt. Das Verfahren dient zum Steuern der Projektionsbelichtungsanlage 10 bei Vorliegen eines elektrischen Kurzschlusses zwischen zwei benachbarten Zonen 346a, 346b des strombeheizten optischen Manipulators 336. Durch den Kurzschluss lassen sich beide Zonen 346a, 346b nur mit gleicher Heizleistung bzw. gleichem Stellweg betreiben.

Das Verfahren lässt sich somit auch bei anderen Manipulatoren mit einer Vielzahl von separat einstellbaren Zonen und einem durch eine Störung bedingten einheitlichen Stellweg für zwei benachbarte Zonen anwenden, z.B. beim Manipulator 136 mit einem adaptiven Spiegel 70 oder beim Manipulator 236 mit einer Beheizung durch Infrarotlicht.

In einem ersten Schritt S01 erfolgt in einem Rechner eine Berechnung von Basiskorrekturvektoren für eine Vielzahl von möglichen oder allen möglichen Kurzschlüssen zwischen zwei benachbarten Zonen 346. Dabei können beispielsweise Kurzschlüsse zwischen bestimmten Zonen 346 auf Grund der Struktur der Leiterbahnen ausgeschlossen oder für wahrscheinlicher als andere erachtet werden. Zur Berechnung eines Basiskorrekturvektors für einen Kurzschluss wird zunächst eine Basisdifferenz zwischen den zwei beteiligten Zonen 346 festgelegt. Beispielsweise wird für die erste Zone als Stellweg der Mittelwert des Sollstellwegbereichs und für die zweite Zone ein maximal möglicher Stellweg verwendet. So kann bei einem Sollstellwegbereich für alle Zonen unter Berücksichtigung der Kühlung von z.B. -65 W/m$^2$ bis +65 W/m$^2$ für die erste Zone 0 W/m$^2$ und für die zweite Zone 65 W/m$^2$ festgelegt werden. Weiterhin werden für alle anderen Zonen 346 von beiden optischen Platten 338, 340 maximale Stellwegbereiche festgelegt, z.B. +/- 20 W/m$^2$ und +/- 0,1 K.

Anschließend werden Stellwege für alle anderen Zonen 346 durch Lösen des folgenden Optimierungsproblems bestimmt: Einhaltung der festgelegten maximalen Stellbereiche für alle anderen Zonen 346 von beiden optischen Platten 338, 340, Festlegung der vorgegeben Werte für die erste und die zweite Zone entsprechend der Basisdifferenz, und minimale Aberration durch die beiden optischen Platten 338, 340. Zusätzlich können die Stellmöglichkeiten anderer Manipulatoren der Projektionsbelichtungsanlage 10 berücksichtigt werden. Der Basiskorrekturvektor enthält dann auch Korrekturwerte für die anderen Manipulatoren. Zur Lösung des Optimierungsproblems kann beispielsweise ein auf quadratischer Programmierung beruhender Algorithmus (QuadProg), eine sequentielle quadratische Programmierung (engl. SQP: Sequential-Quadratic-Programming), eine Tikhonov-Regularisierung und/oder eine Hansen L-Kurven-Methode eingesetzt werden.

Alternativ lassen sich auch andere Basisdifferenzen, wie z.B. eine um den Mittelwert des Sollstellwegbereichs ausgebildete Differenz, wie z.B. -1 W/m$^2$ für die erste Zone und +1 W/m$^2$ für die zweite Zone verwenden. Ebenso ist bei bereits generierten Stellwegen s1 für die erste Zone und s2 für die zweite Zone eine Festlegung der Basisdifferenz durch (s1-s2)/2 für die erste Zone und (s2-s1)/2 für die zweite Zone möglich. Der so ermittelte Basiskorrekturvektor lässt sich unter Verwendung des Mittelwerts (s1+s2)/2 als Stellweg für die erste und zweite Zone unmittelbar als Korrekturwertvektor einsetzen. Mit diesen Vorgaben lässt sich somit auch direkt ein Korrekturwertvektor berechnen.

Ohne Berücksichtigung der anderen Manipulatoren kompensieren die so bestimmten Stellwege für die anderen Zonen 346 die optische Wirkung der vorgegeben Stellwege für die erste und zweite Zone. Umgekehrt induzieren die Stellwege der anderen Zonen bei gleichem Stellweg für die erste und zweite Zone eine optische Wirkung, welche der wegen des Kurzschlusses nicht einstellbaren Basisdifferenz entspricht. Der ermittelte Basiskorrekturvektor lässt sich durch geeignetes Skalieren für andere Differenzen zwischen den Stellwegen der ersten Zone und zweiten Zone anpassen.

In einem zweiten Schritt S02 werden die ermittelten Basiskorrekturwerte für die Projektionsbelichtungsanlage 10 in dem Speicher 68 der Projektionsbelichtungsanlage 10 bereitgestellt. Sie können so unmittelbar nach Auftreten eines Kurzschlusses für eine Korrektur des generierten Stellwegvektors verwendet werden. Alternativ können die Basiskorrekturwerte auch in einem anderen Speicher gespeichert und über ein Netzwerk bereitgestellt werden.

Wird bei einer Überprüfung S03 der Zonen 346 durch die Zonenprüfeinheit 62 der Projektionsbelichtungsanlage 10 ein Kurzschluss zwischen zwei Zonen 346a, 346b detektiert, gibt die Zonenprüfeinheit 62 als Einschränkungsparameter für die kurzgeschlossenen Zonen 346a, 346b einen einheitlichen Stellweg vor. Somit wird das Korrigieren von generierten Stellwegvektoren aktiviert. In einem alternativen Ausführungsbeispiel kann die Berechnung des Basiskorrekturvektors erst jetzt, beispielsweise durch die Korrektureinrichtung 66 erfolgen.

In einem vierten Schritt S04 wird eine Messung oder eine Extrapolation des momentan vorliegenden Wellenfrontfehlers durch das Bestimmungsmodul 54 während des Betriebs der Projektionsbelichtungsanlage 10 ausgeführt. Der gemessene oder extrapolierte Wellenfrontfehler wird anschließend an den Stellweggenerator 56 weitergeleitet.

Anschließend erfolgt ein Generieren S05 eines Stellwegvektors mit Stellwegen für jede Zone 346 des optischen Manipulators 336 und für weitere Manipulatoren der Projektionsbelichtungsanlage 10 durch den Stellweggenerator 56. Das Generieren der Stellwege erfolgt auf Grundlage des gemessenen oder extrapolierten momentanen Wellenfrontfehlers des Projektionsobjektivs 22 in der weiter oben beschrieben Weise.

In einem sechsten Schritt S06 ermittelt die Überprüfungsvorrichtung 64 zunächst, ob ein Einschränkungsparameter bezüglich eines Kurzschlusses zwischen zwei Zonen 346 vorliegt. Ist ein Kurzschluss für zwei Zonen 346a, 346b vorgegeben, findet anschließend eine Überprüfung der für die kurzgeschlossenen Zonen 346a, 346b generierten Stellwege auf Gleichheit durch die Überprüfungsvorrichtung 64 statt.

Falls die generierten Stellwege der kurzgeschlossenen Zonen 346a, 346b gleich sind oder sich weniger als eine vorgegebene Differenz unterscheiden, erfolgt eine Einstellung S07 aller Zonen 346 des optischen Manipulators 336 und auch anderer Manipulatoren der Projektionsbelichtungsanlage 10 entsprechend den Stellwegen des generierten Stellwegvektors zur Kompensation des gemessenen oder extrapolierten Wellenfrontfehlers.

Falls die generierten Stellwege der kurzgeschlossenen Zonen 346a, 346b sich um mehr als eine vorgegebene Differenz unterscheiden, erfolgt ein Korrigieren S08 des generierten Stellwegvektors durch die Korrektureinrichtung 66. Hierfür wird zunächst der in dem Speicher 68 bereitgestellte Basiskorrekturvektor für die kurzgeschlossenen Zonen 346a, 346b ermittelt. Anschließend erfolgt eine Berechnung des Skalierungsfaktors S mittels der Differenz der generierten Stellwege s1 und s2 für die kurzgeschlossenen Zonen 346a, 346b und dem Nominalwert N des Basiskorrekturvektors: S = (s1 - s2) / N. Der Nominalwert entspricht der für die Berechnung des Basiskorrekturvektors verwendeten Basisdifferenz.

Zur Berechnung des Skalierungsfaktors kann in einer alternativen Ausführung anstelle der direkten Differenz der Stellwege s1 und s2 eine mit weiteren Parametern der Zonen 346 gewichtete Differenz zur Berücksichtigung dieser Parameter verwendet werden. Beispielsweise wird bei strombeheizten Zonen mit der Heizleistung P als Stellweg der Skalierungsfaktor S mittels einer gewichteten Differenz $\Delta P$ und der Basisdifferenz $P_N$ als Nominalwert mit S = $\Delta P$ / $P_N$ berechnet. $\Delta P$ kann dabei eine mit den maximal möglichen Heizleistungen der Zonen z1 und z2 gewichtete Differenz zur Berücksichtigung der Widerstandscharakteristik einzelner Zonen darstellen:

$$\Delta P = [P_m(z1) \cdot (P_{NP}(z2) + P_{UC}(z2)) - P_m(z2) \cdot (P_{NP}(z1) + P_{UC}(z1))] / [P_m(z1) + P_m(z2)]$$

$P_m(z)$: Maximal mögliche Heizleistung der kurzgeschlossenen Zonen z1, z2;
$P_{NP}(z)$: Für einen neutralen Zustand des Manipulators vorgegebene Heizleistung der Zonen z1 und z2; und
$P_{UC}(z)$: Zur Kompensation eines Wellenfrontfehlers vorgegebene Heizleistung für die Zonen z1 und z2.

Durch Skalieren des Basiskorrekturvektors mit dem ermittelten Skalierungsfaktor wird der Korrekturwertvektor bestimmt. Anschließend wird ein korrigierter Stellwegvektor durch komponentenweises Addieren der Korrekturwerte des Korrekturwertvektors zu den Stellwegen des generierten Stellwegvektors berechnet. Für die kurzgeschlossenen Zonen 346a, 346b wird als Stellweg in dem korrigierten Stellwegvektor entweder der Mittelwert (s1+s2)/2 der generierten Stellwege bei einer Basisdifferenz von Stellwegen um den Mittelwert des Sollstellwegbereichs, oder der generierte Stellweg für die erste Zone 346a bei einer Basisdifferenz aus Mittelwert und maximalem Wert des Sollstellwegbereichs festgesetzt.

Anschließend erfolgt in Schritt S09 eine Einstellung aller Zonen 346 des optischen Manipulators 336 und auch anderer Manipulatoren der Projektionsbelichtungsanlage 10 entsprechend den Stellwegen des korrigierten Stellwegvektors zur Kompensation des gemessenen oder extrapolierten Wellenfrontfehlers.

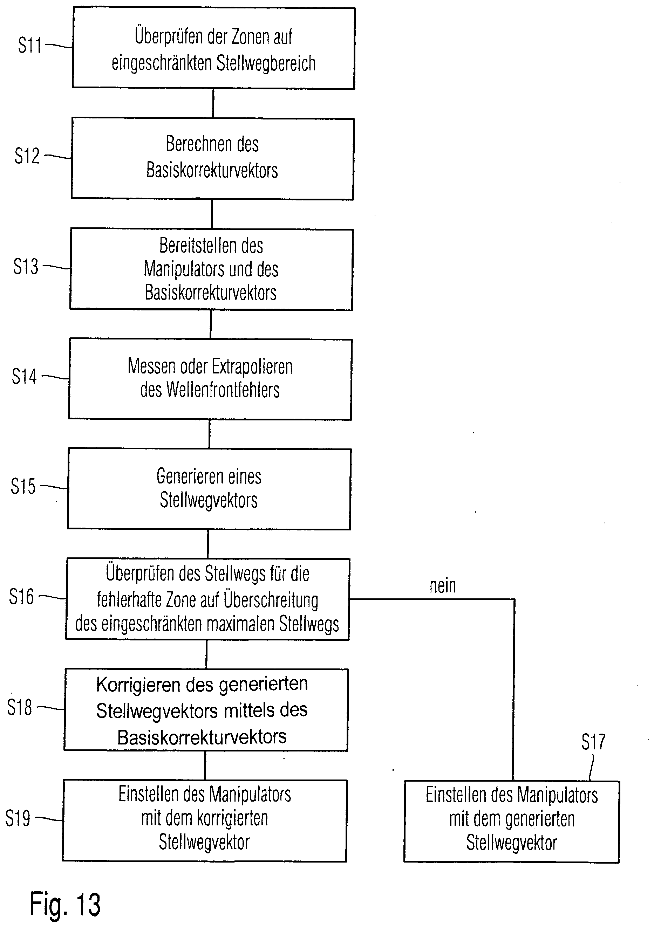

In Fig. 13 wird ein Flussdiagram zur Veranschaulichung eines zweiten Ausführungsbeispiels des Verfahrens zum Steuern der Projektionsbelichtungsanlage 10 dargestellt. Das Verfahren dient zum Steuern der Projektionsbelichtungsanlage 10 bei Vorliegen einer fehlerhaften Zone 346c mit einer außerhalb der Toleranz liegenden Widerstandscharakteristik. Hierdurch wird insbesondere ein eingeschränkter Stellwegbereich der Zone 346c verursacht, wodurch bestimmte generierte Stellwege für die Zone 346c nicht vollständig ausführbar sind. Das Verfahren lässt sich somit auch bei anderen Manipulatoren mit einer Vielzahl von separat einstellbaren Zonen und einer fehlerhaften Zone mit eingeschränktem Stellwegbereich anwenden, wie beispielsweise beim Manipulator 136 mit einem adaptiven Spiegel oder dem Manipulator 236 mit einer Beheizung durch Infrarotlicht.

In einem ersten Schritt S11 erfolgt bereits bei der Herstellung der optischen Platten 338, 340 oder des optischen Manipulators 336 eine Überprüfung aller Zonen 346 auf Vorliegen eines eingeschränkten Stellwegbereichs auf Grund einer außerhalb des Sollbereichs liegenden Widerstandscharakteristik.

Wird ein eingeschränkter Stellwegbereich bei einer Zone 346c festgestellt, erfolgt in einem zweiten Schritt S12 eine Berechnung eines Basiskorrekturvektors für die fehlerhafte Zone 346c. Dazu wird zunächst ein maximaler Korrekturstellweg bestimmt. Beispielsweise wird als maximaler Korrekturstellweg der nicht ausführbare Anteil eines maximalen Sollstellwegs festgelegt. Zusätzlich werden für alle anderen Zonen 346 von beiden optischen Platten 338, 340 maximale Stellwegbereiche festgelegt, z.B. +/- 20 W/m$^2$ und +/- 0,1 K für jede Zone.

Anschließend werden Stellwege für alle anderen Zonen 346 durch Lösen des folgenden Optimierungsproblems bestimmt: Einhaltung der festgelegten maximalen Stellbereiche für alle anderen Zonen 346 von beiden optischen Platten 338, 340, Festlegung des maximalen Korrekturstellwegs für die defekte Zone 346c, und minimale Aberration durch die beiden optischen Platten 338, 340. Zusätzlich können die Stellmöglichkeiten anderer Manipulatoren der Projektionsbelichtungsanlage 10 berücksichtigt werden. Der Basiskorrekturvektor enthält dann auch Korrekturwerte für die anderen Manipulatoren. Zur Lösung des Optimierungsproblems kann beispielsweise ein auf quadratischer Programmierung beruhender Algorithmus (QuadProg), eine sequentielle quadratische Programmierung (engl. SQP: Sequential-Quadratic-Programming), eine Tikhonov-Regularisierung und/ oder eine Hansen L-Kurven-Methode eingesetzt werden.

Die Stellwege des so ermittelten Basiskorrekturvektors erzeugen eine optische Wirkung des optischen Manipulators 336, welche dem nicht ausführbaren Anteil eines maximalen Stellwegs für die fehlerhafte Zone entspricht. Der Basiskorrekturvektor lässt sich durch geeignetes Skalieren an andere nicht vollständig ausführbare Stellwege für die fehlerhafte Zone 346c anpassen.

In einem dritten Schritt S13 wird der optische Manipulator 336 zusammen mit dem ermittelten Basiskorrekturvektor für die Projektionsbelichtungsanlage bereitgestellt. Dabei erfolgt ein Speichern des Basiskorrekturvektors in dem Speicher 68 der Projektionsbelichtungsanlage 10. Zusätzlich wird als Einschränkungsparameter ein eingeschränkter, maximal möglicher Stellweg für die Zone 346c eingestellt. Diese kann z.B. mittels der Zonenprüfeinheit 62 ausgeführt werden. Es erfolgt somit eine Aktivierung der Korrektur von generierten Stellwegvektoren.

Anschließend erfolgt während des Betriebs der Projektionsbelichtungsanlage 10 eine Messung oder Extrapolation S14 des momentan vorliegenden Wellenfrontfehlers des Projektionsobjektivs 22 und eine Generierung S15 eines Stellwegvektors. Diese Schritte entsprechen den Schritten S04 und S05 des Ausführungsbeispiels nach Fig. 12.

In einem sechsten Schritt S16 erfolgt zunächst eine Prüfung auf Vorliegen eines Einschränkungsparameters mit einem eingeschränkten maximalen Stellweg für eine Zone 346 durch die Überprüfungseinrichtung 64. Liegt eine Einschränkung bezüglich des maximalen Stellwegs für eine Zone 346c vor, findet anschließend eine Überprüfung des für die fehlerhafte Zone 346c generierten Stellwegvektors auf Überschreitung des eingeschränkten maximalen Stellwegs für Zone 346c statt.

Falls der generierte Stellweg der fehlerhaften Zone 346c den eingeschränkten maximalen Stellweg nicht überschreitet, erfolgt eine Einstellung S17 aller Zonen 346 des optischen Manipulators 336 und auch anderer Manipulatoren der Projektionsbelichtungsanlage 10 entsprechend den Stellwegen des generierten Stellwegvektors zur Kompensation des gemessenen oder extrapolierten Wellenfrontfehlers.

Falls der generierte Stellweg der fehlerhaften Zone 346c den eingeschränkten maximalen Stellweg überschreitet, erfolgt ein Korrigieren S18 des generierten Stellwegvektors durch die Korrektureinrichtung 66. Es wird zunächst der in dem Speicher 68 bereitgestellte Basiskorrekturvektor für die fehlerhafte Zone 346c ermittelt. Anschließend erfolgt eine Berechnung eines Skalierungsfaktors S mittels der Differenz $\Delta s$ zwischen dem generierten Stellweg und dem eingeschränkten maximalen Stellweg, und dem Nominalwert N des Basiskorrekturvektors: $S = \Delta s / N$. Der Nominalwert entspricht dem bei der Berechnung des Basiskorrekturvektors verwendeten maximalen Korrekturstellweg. Durch Skalieren des Basiskorrekturvektors mit dem ermittelten Skalierungsfaktor erfolgt die Bestimmung des Korrekturwertvektors. Anschließend wird ein korrigierter Stellwegvektor durch komponentenweises Addieren der Korrekturwerte des Korrekturwertvektors zu den Stellwerten des generierten Stellwegvektors berechnet. Für die fehlerhafte Zone 346c wird als Stellweg in dem korrigierten Stellwegvektor der eingeschränkte maximale Stellweg festgelegt.

In Schritt S19 erfolgt schließlich eine Einstellung aller Zonen 346 des optischen Manipulators 336 und auch anderer Manipulatoren der Projektionsbelichtungsanlage 10 entsprechend den Stellwegen des korrigierten Stellwegvektors zur Kompensation des gemessenen oder extrapolierten Wellenfrontfehlers.

Die nach Schritt S12 berechneten Basiskorrekturvektoren lassen sich in einem weiteren Ausführungsbeispiel des Verfahrens auch zur Kompensation einer Stellwegabschneidung in Folge einer Übersteuerung durch einen über den maximalen Sollstellweg hinausgehenden, generierten Stellweg verwenden. Dabei erfolgt zunächst eine Überprüfung aller Stellwege des generierten Stellwegvektors auf Überschreitung des maximalen Sollstellwegs. Falls eine Überschreitung vorliegt, wird analog zu Schritt S18 ein Basiskorrekturvektor für die betroffene Zone 346 ermittelt, ein Skalierungsfaktor bestimmt und ein Korrekturwertvektor berechnet. Bei der Ermittlung des Skalierungsfaktors wird nun anstelle des eingeschränkten maximalen Stellwegs der maximale Sollstellweg verwendet. Anschließend erfolgt eine Einstellung aller Zonen 346 des optischen Manipulators 336 und weiterer Manipulatoren gemäß Schritt S19.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren. Daher sollen alle derartigen Abänderungen und Modifikationen, insoweit sie in den Rahmen der Erfindung gemäß der Definition in den beigefügten Ansprüchen fallen, vom Schutz der Ansprüche abgedeckt sein.

**Bezugszeichenliste**

| | |
|---|---|
| 10 | Projektionsbelichtungsanlage |
| 12 | Maske |
| 14 | Substrat |
| 16 | Strahlungsquelle |
| 18 | Beleuchtungssystem |
| 20 | optisches Element des Beleuchtungssystems |
| 22 | Projektionsobjektiv |
| 24 | Objektebene |
| 26 | Bildebene |
| 28 | Linse des Projektionsobjektivs |
| 30 | Positionierungsvorrichtung Maske |
| 32 | Positionierungsvorrichtung Substrat |
| 34 | optische Achse |
| 48 | Strahlengang |
| 52 | Manipulatorsteuerung |
| 54 | Bestimmungsmodul |
| 56 | Stellweggenerator |
| 58 | Wellenfrontsensor |
| 60 | Speicher Stellweggenerator |
| 62 | Zonenprüfeinheit |
| 64 | Überprüfungseinrichtung |
| 66 | Korrektureinrichtung |
| 68 | Speicher |
| 70 | Spiegel des Projektionsobjektivs |
| 136 | optischer Manipulator |
| 136a | optischer Manipulator |
| 136b | optischer Manipulator |
| 136c | optischer Manipulator |
| 138 | Manipulationseinrichtung |

| | |
|---|---|
| 140 | Aktuator |
| 142 | Rückseite Spiegel |
| 144 | reflektierende Beschichtung |
| 145 | Spiegelhalterung |
| 146 | Zone |
| 148 | Gehäuse |
| 150 | Drucksensor |
| 152 | Antriebselement |
| 154 | Feder |
| 156 | Kontaktelement |
| 158 | optische Achse des Spiegels |
| 160 | Trägerplatte |
| 162 | Ausnehmung |
| 164 | Spiegelpfosten |
| 166 | Positionssensor |
| 168 | L-förmiger Hebel |
| 170 | Verbindungselement |
| 172 | Feder |
| 174 | Befestigungselement |
| 176 | hervorstehendes Teil des Spiegels |
| 180 | piezoelektrische Schicht |
| 182 | Substrat |
| 184 | elektrische Leitung |
| 185 | erste Kontaktfläche |
| 186 | zweite Kontaktfläche |
| 188 | Durchkontaktierung |
| 190 | Isolationsschicht |
| 192 | Steuerelektroden |
| 194 | Gegenelektrode |
| 196 | Schutzschicht |
| 236 | optischer Manipulator |
| 238 | Bestrahlungseinheit |
| 240 | Infrarotlichtquelle |
| 244 | IR-Strahlung |
| 245 | fotoelektrischer Sensor |
| 246 | Zone |
| 248 | Umlenkspiegel |
| 250 | Lichtwellenleiter |
| 252 | erste Kondensorlinse |
| 254 | Strahlteiler |
| 256 | fotoelektrischer Sensor |
| 258 | zweite Kondensorlinse |
| 260 | Halterung |
| 264 | Querschnitt Belichtungsstrahlengang |
| 336 | optischer Manipulator |
| 338 | erste optische Platte |
| 340 | zweite optische Platte |
| 342 | Spalt |
| 344 | Luftströmung |
| 346 | beheizbare Zone |
| 346a | kurzgeschlossene Zone |
| 346b | kurzgeschlossene Zone |
| 346c | fehlerhafte Zone |
| 350 | Aktuierungseinrichtung |

**Patentansprüche**

1. Verfahren zum Steuern einer Projektionsbelichtungsanlage (10) für die Mikrolithographie mit einem Projektionsobjektiv (22) sowie mindestens einem in einem Strahlengang des Projektionsobjektivs (22) angeordneten optischen Manipulator (136, 236, 336), welcher eine Vielzahl von über einen Querschnitt des Strahlengangs (48) verteilten Zonen (146, 246 346) mit individuell einstellbarer optischer Wirkung im Strahlengang (48) aufweist, umfassend die Schritte:

   - Bestimmen eines Wellenfrontfehlers in einem Bildfeld der Projektionsbelichtungsanlage (10);
   - Generieren eines zur Korrektur des Wellenfrontfehlers geeigneten Stellwegvektors mit Stellwegen für jede Zone (146, 246, 346) des optischen Manipulators (136, 236, 336) mittels eines stellweggenerierenden Optimierungsalgorithmus auf Grundlage des bestimmten Wellenfrontfehlers;
   - Ermitteln eines Einschränkungsparameters bezüglich des Stellwegs für mindestens eine Zone des optischen Manipulators;
   - Überprüfen der Stellwege des generierten Stellwegvektors auf Ausführbarkeit unter Berücksichtigung des ermittelten Einschränkungsparameters und Ausführen der folgenden Schritte bei Vorliegen einer Einschränkung in der Ausführbarkeit:

      Beschaffen eines Korrekturwertvektors mit Korrekturwerten für mehrere der Zonen des optischen Manipulators auf Grundlage des Einschränkungsparameters und des generierten Stellwegvektors,
      Ermitteln eines korrigierten Stellwegvektors durch Korrektur der Stellwege des generierten Stellwegvektors anhand der entsprechenden Korrekturwerte des Korrekturwertvektors, und
      Einstellen der optischen Wirkung aller Zonen (146, 246, 346) des optischen Manipulators mit Hilfe des korrigierten Stellwegvektors zur Kompensation des Wellenfrontfehlers.

2. Verfahren nach Anspruch 1,
   wobei der Einschränkungsparameter einen maximal zulässigen Stellweg für mindestens eine Zone (146, 246 346) des optischen Manipulators (136, 236, 336)
   vorgibt.

3. Verfahren nach Anspruch 1 oder 2,
   weiterhin umfassend ein Prüfen einer Aktuatorcharakteristik der Zonen (146, 246, 346) des optischen Manipulators (136, 236, 336) auf Einhaltung einer Sollvorgabe für einen Stellwegbereich und Festlegen des Einschränkungsparameters auf einen maximal zulässigen Stellweg für eine fehlerhafte Zone (346c) mit einer von der Sollvorgabe abweichenden Aktuatorcharakteristik.

4. Verfahren nach einem der vorausgehenden Ansprüche,
   wobei der optische Manipulator (136) einen deformierbaren Spiegel (136a, 136b, 136c) umfasst, die Zonen jeweils deformierbare Bereiche einer reflektierenden Beschichtung des Spiegels sind, und ein Einstellen der optischen Wirkung für jede Zone des deformierbaren Spiegels durch eine Deformierung entsprechend den Stellwegen des korrigierten Stellwegvektors erfolgt.

5. Verfahren nach einem der vorausgehenden Ansprüche,
   wobei der optische Manipulator (236) eine Bestrahlungseinrichtung (238) sowie ein in einem Strahlengang (48) des Projektionsobjektivs (22) angeordnetes optisches Element (28) umfasst, die Zonen (246) auf dem optischen Element (28) von der Bestrahlungseinrichtung jeweils separat mit Strahlung einer Wellenlänge, welche von einer Belichtungswellenlänge der Projektionsbelichtungsanlage (10) abweicht, derart bestrahlt werden, dass aufgrund einer Aufheizung der Zonen die optische Wirkung zur Kompensation des Wellenfrontfehlers erzielt wird.

6. Verfahren nach einem der vorausgehenden Ansprüche,
   wobei die jeweilige optische Wirkung der Zonen (146, 246, 346) mittels jeweiliger Steuersignale einstellbar ist und wobei weiterhin ein Prüfen auf eine fehlerhafte Gleichschaltung der Steuersignale zweier Zonen erfolgt und der Einschränkungsparameter bei Vorliegen einer fehlerhaften Gleichschaltung einen einheitlichen Stellweg für die beiden betroffenen Zonen vorgibt.

7. Verfahren nach Anspruch 6,
   wobei der optische Manipulator als deformierbarer Spiegel (136c) konfiguriert ist, bei dem die optische Wirkung der Zonen (146) mittels an einer piezoelektrischen Schicht (180) anliegenden Steuerelektroden (192) individuell einstellbar ist, und die fehlerhafte Gleichschaltung der Steuersignale zweier Zonen durch einen Kurzschluss zweier benachbarter Steuerelektroden erfolgt.

**8.** Verfahren nach Anspruch 6,
wobei der optische Manipulator (336) als strombetriebener thermischer Manipulator konfiguriert ist, bei dem die Steuersignale zur Einstellung der optischen Wirkung der Zonen (346) durch individuelle elektrische Beheizung der Zonen erzeugt werden, wobei weiterhin das Prüfen auf ein fehlerhaftes Gleichschalten der Steuersignale zweier Zonen ein Prüfen auf einen elektrischen Kurzschluss in der Beheizung zweier benachbarter Zonen (346a, 346b) umfasst, der bewirkt, dass beide Zonen (346a, 346b) gleich stark beheizt werden, und der Einschränkungsparameter bei Vorliegen eines Kurzschlusses einen einheitlichen Stellweg für die beiden benachbarten Zonen (346a, 346b) vorgibt.

**9.** Verfahren nach einem der vorgehenden Ansprüche,
wobei das Beschaffen des Korrekturwertvektors eine Auswahl eines Korrekturwertvektors aus einer Vielzahl von für die Projektionsbelichtungsanlage (10) in einem Speicher (68) bereitgestellten Korrekturwertvektoren umfasst.

**10.** Verfahren nach einem der Ansprüche 1 bis 8,
wobei das Beschaffen des Korrekturwertvektors ein Ermitteln eines Basiskorrekturvektors mit Basisstellwegen auf Grundlage des Einschränkungsparameters, ein Ermitteln eines Skalierungsfaktors auf Grundlage des generierten Stellwegvektors und des ermittelten Basiskorrekturvektors, sowie ein Berechnen des Korrekturwertvektors durch Skalieren des Basiskorrekturvektors mit dem ermittelten Skalierungsfaktor umfasst.

**11.** Verfahren nach Anspruch 10,
wobei das Ermitteln des Basiskorrekturvektors bei Vorliegen einer fehlerhaften Zone (346c) des optischen Manipulators (336) mit einem von einer Sollvorgabe abweichenden Stellwegbereich die folgenden Schritte umfasst:

- Bestimmen eines maximalen Korrekturstellwegs für die fehlerhafte Zone (346c) basierend auf der Sollvorgabe und des tatsächlichen Stellwegbereichs,
- Bestimmen von maximalen Stellwegbereichen für alle anderen Zonen (346) des Manipulators, und
- Lösen eines Optimierungsproblems mit dem maximalen Korrekturstellweg der fehlerhaften Zone (346c), dem maximalen Stellwegbereichen aller anderen Zonen (346) und einer minimalen oder vorgegebenen Aberration als Zwangsbedingungen zur Bestimmung der Basisstellwege des Basiskorrekturvektors.

**12.** Verfahren nach Anspruch 11,
wobei das Ermitteln des Skalierungsfaktors bei Vorliegen einer fehlerhafte Zone (346c) des optischen Manipulators (136, 236, 336) mit einem von einer Sollvorgabe abweichenden Stellwegbereich auf einem Überschreitungswert des Stellwegbereichs durch den generierten Stellweg und einer Nominalauslegung des für die fehlerhafte Zone ermittelten Basiskorrekturvektors basiert.

**13.** Verfahren nach Anspruch 10 oder 11,
wobei die jeweilige optische Wirkung der Zonen (146, 246, 346) mittels jeweiliger Steuersignale einstellbar ist und wobei weiterhin das Ermitteln des Basiskorrekturvektors umfasst: ein Berechnen eines Basiskorrekturvektors für zwei Zonen (346a, 346b) des Manipulators (336), deren Steuersignale gleichgeschaltet sind, durch Lösen eines Optimierungsproblems mit vorgegebener Differenz zwischen unterschiedlichen Stellwegen für die zwei Zonen (346a, 346b) mit gleichgeschalteten Steuersignalen, maximalen Stellwegbereichen für alle anderen Zonen (346) des optischen Manipulators und minimaler Aberration als Zwangsbedingungen zur Bestimmung der Basisstellwege des Basiskorrekturvektors.

**14.** Verfahren nach einem der vorausgehenden Ansprüche,
wobei der optische Manipulator (336) eine für die Belichtungsstrahlung der Projektionsbelichtungsanlage (10) transparente Platte (338) enthält, deren optische Wirkung temperaturabhängig ist, die Zonen (346) jeweils separate, elektrisch beheizbare Bereiche der Platte (338) sind, und ein Einstellen der optischen Wirkung für jede Zone (346) der transparenten Platte (338) durch eine Beheizung entsprechend den Stellwegen des korrigierten Stellwegvektors erfolgt.

**15.** Projektionsbelichtungsanlage für die Mikrolithographie, enthaltend:

- ein Projektionsobjektiv (22) zum Abbilden einer Maske (12) aus einer Objektebene (24) des Projektionsobjektivs in eine Bildebene (26) des Projektionsobjektivs;
- mindestens einen optischen Manipulator (136, 236, 336) in einem Strahlengang des Projektionsobjektivs (22), wobei der optische Manipulator eine Vielzahl von über einen Querschnitt des Strahlengangs (48) verteilten Zonen (146, 246, 346) mit individuell einstellbarer optischer Wirkung im Strahlengang (48) aufweist;
- ein Bestimmungsmodul (54) zum Bestimmen eines Wellenfrontfehlers in einem Bildfeld der Projektionsbelichtungsanlage (10);
- einen Stellweggenerator (56) zum Generieren eines zur Korrektur des Wellenfrontfehlers geeigneten Stellwegvektors mit Stellwegen für jede Zone (146, 246, 346) des optischen Manipulators (136, 236, 336) mittels eines stellweggenerierenden Optimierungsalgorithmus auf Grundlage des bestimmten Wellenfrontfehlers;
- eine Prüfeinrichtung (62, 64) zum Ermitteln eines Einschränkungsparameters bezüglich des Stellwegs für mindestens eine Zone (146, 246, 346) des optischen Manipulators (136, 236, 336) und zum Überprüfen der Stellwege des generierten Stellwegvektors auf Ausführbarkeit unter Berücksichtigung des ermittelten Einschränkungsparameters;
- eine Korrektureinrichtung (66) zum Korrigieren des generierten Stellwegvektors bei einer Einschränkung der Ausführbarkeit mindestens eines Stellwegs, wobei die Korrektureinrichtung zum Beschaffen eines Korrekturwertvektors mit Korrekturwerten für mehrere der Zonen (146, 246, 346) des optischen Manipulators basierend auf dem Einschränkungsparameter und dem generierten Stellwegvektor und zum Ermitteln eines korrigierten Stellwegvektors durch Korrektur der Stellwege des generierten Stellwegvektors anhand der entsprechenden Korrekturwerte des Korrekturwertvektors ausgebildet ist; und
- eine Aktuierungseinrichtung (50) zum Einstellen aller Zonen (146, 246, 346) des optischen Manipulators (136, 236, 336) mit Hilfe des korrigierten Stellwegvektors zur Kompensation des Wellenfrontfehlers.

**Claims**

1. Method for controlling a microlithographic projection exposure apparatus (10), comprising a projection lens (22) and at least one optical manipulator (136, 236, 336) arranged in a beam path of the projection lens (22), which optical manipulator has a multiplicity of zones (146, 246, 346), distributed over a cross section of the beam path (48), with an individually adjustable optical effect in the beam path (48), comprising the following steps:

   - determining a wavefront error in an image field of the projection exposure apparatus (10);
   - generating a travel vector, suitable for correcting the wavefront error, with travels for each zone (146, 246, 346) of the optical manipulator (136, 236, 336) by means of a travel-generating optimization algorithm on the basis of the determined wavefront error;
   - establishing a constraint parameter in respect of the travel for at least one zone of the optical manipulator;
   - checking the travels of the generated travel vector in respect of implementability taking into account the established constraint parameter and implementing the following steps if there is a constraint in the implementability:

      obtaining a correction value vector with correction values for a plurality of the zones of the optical manipulator on the basis of the constraint parameter and the generated travel vector,
      establishing a corrected travel vector by correcting the travels of the generated travel vector on the basis of the corresponding correction values of the correction value vector, and
      adjusting the optical effect of all zones (146, 246, 346) of the optical manipulator with the aid of the corrected travel vector for compensating the wavefront error.

2. Method according to Claim 1,
   wherein the constraint parameter prescribes a maximum admissible travel for at least one zone (146, 246, 346) of the optical manipulator (136, 236, 336).

3. Method according to Claim 1 or 2,
   furthermore comprising a testing of an actuator characteristic of the zones (146, 246, 346) of the optical manipulator (136, 236, 336) in respect of observing a target specification for a travel range and fixing of the constraint parameter at a maximum admissible travel for a faulty zone (346c) with an actuator characteristic deviating from the target specification.

4. Method according to one of the preceding claims,
   wherein the optical manipulator (136) comprises a deformable mirror (136a, 136b, 136c), the zones are respectively deformable regions of a reflecting coating of the mirror, and the optical effect for each zone of the deformable mirror is adjusted by a deformation in accordance with the travels of the corrected travel vector.

5. Method according to one of the preceding claims,
   wherein the optical manipulator (236) comprises an irradiation device (238) and an optical element (28) arranged in a beam path (48) of the projection lens (22), the zones (246) on the optical element (28) being irradiated by the irradiation device, separately in each case with radiation at a wavelength deviating from an exposure wavelength of the projection exposure apparatus (10), in such a way that the optical effect for compensating the wavefront error is obtained due to heating of the zones.

6. Method according to one of the preceding claims,
   wherein the respective optical effect of the zones (146, 246, 346) is adjustable by means of respective control signals and wherein, furthermore, there is testing for an erroneous synchronization of the control signals of two zones and the constraint parameter prescribes a uniform travel for the two affected zones if an erroneous synchronization is present.

7. Method according to Claim 6,
   wherein the optical manipulator is configured as a deformable mirror (136c), in which the optical effect of the zones (146) is individually adjustable by means of control electrodes (192) contacting a piezoelectric layer (180), and the erroneous synchronization of the control signals of two zones is carried out by a short circuit of two adjacent control electrodes.

8. Method according to Claim 6,
   wherein the optical manipulator (336) is configured as a current-operated thermal manipulator, in which the control signals for adjusting the optical effect of the zones (346) are generated by individual electrical heating of the zones, wherein, furthermore, the testing for an erroneous synchronization of the control signals of two zones comprises testing for an electrical short circuit in the heating of two adjacent zones (346a, 346b), said short circuit causing both zones (346a, 346b) to be heated to the same extent, and the constraint parameter prescribes a uniform travel for the two adjacent zones (346a, 346b) if a short circuit is present.

9. Method according to one of the preceding claims,
   wherein the obtaining of the correction value vector comprises a selecting of a correction value vector from a multiplicity of correction value vectors provided for the projection exposure apparatus (10) in a memory (68) .

10. Method according to one of Claims 1 to 8,
    wherein the obtaining of the correction value vector comprises an establishing of a base correction vector with base travels on the basis of the constraint parameter, an establishing of a scaling factor on the basis of the generated travel vector and the established base correction vector, and a calculating of the correction value vector by scaling the base correction vector with the established scaling factor.

11. Method according to Claim 10,
    wherein the establishing of the base correction vector if a faulty zone (346c) of the optical manipulator (336) with a travel range deviating from a target specification is present comprises the following steps:

    - determining a maximum correction travel for the faulty zone (346c) on the basis of the target specification and the actual travel range,
    - determining maximum travel ranges for all other zones (346) of the manipulator, and
    - solving an optimization problem with the maximum correction travel of the faulty zone (346c), the maximum travel ranges of all other zones (346) and a minimum or predetermined aberration as constraints for determining the base travels of the base correction vector.

12. Method according to Claim 11,
    wherein the establishing of the scaling factor if a faulty zone (346c) of the optical manipulator (136, 236, 336) with a travel range deviating from a target specification is present is based on an exceedance value of the travel range by the generated travel and a nominal design of the base correction vector established for the faulty zone.

13. Method according to Claim 10 or 11,
    wherein the respective optical effect of the zones (146, 246, 346) is adjustable by means of respective control signals

**EP 3 048 486 B1**

and wherein, furthermore, the establishing of the base correction vector comprises: a calculating of a base correction vector for two zones (346a, 346b) of the manipulator (336), the control signals of which are synchronized, by solving an optimization problem with the predetermined difference between different travels for the two zones (346a, 346b) with synchronized control signals, maximum travel ranges for all other zones (346) of the optical manipulator and minimum aberration as constraints for determining the base travels of the base correction vector.

14. Method according to one of the preceding claims,
   wherein the optical manipulator (336) contains a plate (338) transparent to the exposure radiation of the projection exposure apparatus (10), the optical effect of said plate being temperature-dependent, the zones (346) respectively are separate, electrically heatable regions of the plate (338) and an adjusting of the optical effect for each zone (346) of the transparent plate (338) is carried out by heating in accordance with the travels of the corrected travel vector.

15. Microlithographic projection exposure apparatus, comprising:

   - a projection lens (22) for imaging a mask (12) from an object plane (24) of the projection lens into an image plane (26) of the projection lens;
   - at least one optical manipulator (136, 236, 336) in a beam path of the projection lens (22), wherein the optical manipulator has a multiplicity of zones (146, 246, 346), distributed over a cross section of the beam path (48), with an individually adjustable optical effect in the beam path (48);
   - a determination module (54) for determining a wavefront error in an image field of the projection exposure apparatus (10);
   - a travel generator (56) for generating a travel vector, suitable for correcting the wavefront error, with travels for each zone (146, 246, 346) of the optical manipulator (136, 236, 336) by means of a travel-generating optimization algorithm on the basis of the determined wavefront error;
   - a test device (62, 64) for establishing a constraint parameter in respect of the travel for at least one zone (146, 246, 346) of the optical manipulator (136, 236, 336) and for checking the travels of the generated travel vector in respect of implementability taking into account the established constraint parameter;
   - a correction device (66) for correcting the generated travel vector in the case of a restriction in the implementability of at least one travel, wherein the correction device is embodied to obtain a correction value vector with correction values for a plurality of the zones (146, 246, 346) of the optical manipulator on the basis of the constraint parameter and the generated travel vector and to establish a corrected travel vector by correcting the travels of the generated travel vector on the basis of the corresponding correction values of the correction value vector; and
   - an actuation device (50) for adjusting all zones (146, 246, 346) of the optical manipulator (136, 236, 336) with the aid of the corrected travel vector for compensating the wavefront error.

**Revendications**

1. Procédé de commande d'un équipement d'exposition par projection (10) pour la microlithographie, comprenant un objectif de projection (22) ainsi qu'au moins un manipulateur optique (136, 236, 336) qui est disposé dans un trajet de rayon de l'objectif de projection (22), lequel possède une pluralité de zones (146, 246, 346) ayant un effet optique réglable individuellement dans le trajet de rayon (48) et distribuées sur une section transversale du trajet de rayon (48), comprenant les étapes suivantes :

   - définition d'une erreur de front d'onde dans un champ d'image de l'équipement d'exposition par projection (10) ;
   - génération d'un vecteur de course de réglage adapté à la correction de l'erreur de front d'onde avec des courses de réglage pour chaque zone (146, 246, 346) du manipulateur optique (136, 236, 336) au moyen d'un algorithme d'optimisation générant des courses de réglage sur la base de l'erreur de front d'onde définie ;
   - détermination d'un paramètre de limitation concernant la course de réglage pour au moins une zone du manipulateur optique ;
   - contrôle de l'aptitude à l'exécution des courses de réglage du vecteur de course de réglage généré en tenant compte du paramètre de limitation déterminé et exécution des étapes suivantes en présence d'une limitation dans l'aptitude à l'exécution :

      acquisition d'un vecteur de valeur de correction avec des valeurs de correction pour plusieurs des zones du manipulateur optique sur la base du paramètre de limitation et du vecteur de course de réglage généré,

24

détermination d'un vecteur de course de réglage corrigé en corrigeant les courses de réglage du vecteur de course de réglage généré à l'aide des valeurs de correction correspondantes du vecteur de valeur de correction, et

réglage de l'effet optique de toutes les zones (146, 246, 346) du manipulateur optique à l'aide du vecteur de course de réglage corrigé en vue de compenser l'erreur de front d'onde.

2. Procédé selon la revendication 1, le paramètre de limitation prédéfinissant une course de réglage maximale autorisée pour au moins une zone (146, 246 346) du manipulateur optique (136, 236, 336).

3. Procédé selon la revendication 1 ou 2, comprenant en outre un contrôle si une caractéristique d'actionneur des zones (146, 246, 346) du manipulateur optique (136, 236, 336) respecte une consigne prédéfinie pour une plage de course de réglage et une fixation du paramètre de limitation à une course de réglage maximale autorisée pour une zone défaillante (346c) avec une caractéristique d'actionneur différente de la consigne prédéfinie.

4. Procédé selon l'une des revendications précédentes, le manipulateur optique (136) comportant un miroir déformable (136a, 136b, 136c), les zones étant respectivement des zones déformables d'un revêtement réfléchissant du miroir, et un réglage de l'effet optique pour chaque zone du miroir déformable s'effectuant par une déformation en fonction des courses de réglage du vecteur de course de réglage corrigé.

5. Procédé selon l'une des revendications précédentes, le manipulateur optique (236) comportant un dispositif d'irradiation (238) ainsi qu'un élément optique (28) disposé dans un trajet de rayon (48) de l'objectif de projection (22), les zones (246) sur l'élément optique (28) étant irradiées par le dispositif d'irradiation, respectivement séparément avec un rayonnement à une longueur d'onde qui est différente d'une longueur d'onde d'exposition de l'équipement d'exposition par projection (10), de telle sorte que l'effet optique destiné à la compensation de l'erreur de front d'onde est obtenu en raison d'un chauffage des zones.

6. Procédé selon l'une des revendications précédentes, l'effet optique respectif des zones (146, 246, 346) étant réglable au moyen de signaux de commande respectifs et un contrôle d'une défaillance de synchronisation des signaux de commande de deux zones étant en outre effectué et le paramètre de limitation, en présence d'une synchronisation défaillante, prédéfinissant une course de réglage homogène pour les deux zones concernées.

7. Procédé selon la revendication 6, le manipulateur optique étant réalisé sous la forme d'un miroir déformable (136c) avec lequel l'effet optique des zones (146) peut être réglé individuellement au moyen d'électrodes de commande (192) appliquées sur une couche piézoélectrique (180), et la synchronisation défaillante des signaux de commande de deux zones ayant lieu par un court-circuit de deux électrodes de commande voisines.

8. Procédé selon la revendication 6, le manipulateur optique (336) étant configuré sous la forme d'un manipulateur thermique piloté par courant avec lequel les signaux de commande destinés au réglage de l'effet optique des zones (346) sont générés par un chauffage électrique individuel des zones, le contrôle de la défaillance de synchronisation des signaux de commande de deux zones comprenant en outre un contrôle de la présence d'un court-circuit électrique dans le dispositif de chauffage de deux zones (346a, 346b) voisines, lequel a pour effet que les deux zones (346a, 346b) sont chauffées avec la même intensité, et le paramètre de limitation, en présence d'un court-circuit, prédéfinissant une course de réglage homogène pour les deux zones (346a, 346b) voisines.

9. Procédé selon l'une des revendications précédentes, l'acquisition du vecteur de valeur de correction comprenant une sélection d'un vecteur de valeur de correction parmi une pluralité de vecteurs de valeur de correction mis à disposition dans une mémoire (68) pour l'équipement d'exposition par projection (10) .

10. Procédé selon l'une des revendications 1 à 8, l'acquisition du vecteur de valeur de correction comprenant une détermination d'un vecteur de correction de base avec des courses de réglage de base sur la base du paramètre de limitation, une détermination d'un facteur de mise à l'échelle sur la base du vecteur de course de réglage généré et du vecteur de correction de base déterminé, ainsi qu'un calcul du vecteur de valeur de correction par mise à l'échelle du vecteur de correction de base avec le vecteur de mise à l'échelle déterminé.

11. Procédé selon la revendication 10, la détermination du vecteur de correction de base, en présence d'une zone défaillante (346c) du manipulateur optique (336) avec une plage de course de réglage différente d'une consigne prédéfinie, comprenant les étapes suivantes :

- définition d'une course de réglage de correction maximale pour la zone défaillante (346c) en se basant sur la consigne prédéfinie et la plage de course de réglage effective,
- définition de plages de course de réglage maximales pour toutes les autres zones (346) du manipulateur, et
- résolution d'un problème d'optimisation avec la course de réglage de correction maximale de la zone défaillante (346c), les plages de course de réglage maximales de toutes les autres zones (346) et une aberration minimale ou prédéfinie en tant que conditions obligatoires pour la définition des courses de réglage de base du vecteur de correction de base.

12. Procédé selon la revendication 11, la détermination du facteur de mise à l'échelle en présence d'une zone défaillante (346c) du manipulateur optique (136, 236, 336) avec une plage de course de réglage différente d'une consigne prédéfinie se basant sur une valeur de dépassement de la plage de course de réglage par la course de réglage générée et une conception nominale du vecteur de correction de base déterminé pour la zone défaillante.

13. Procédé selon la revendication 10 ou 11, l'effet optique respectif des zones (146, 246, 346) étant réglable au moyen de signaux de commande respectifs et la détermination du vecteur de correction de base comprenant en outre : un calcul d'un vecteur de correction de base pour deux zones (346a, 346b) du manipulateur (336) dont les signaux de commande sont synchronisés par résolution d'un problème d'optimisation avec une différence prédéfinie entre des courses de réglage différentes pour les deux zones (346a, 346b) aux signaux de commande synchronisés, des plages de course de réglage maximales pour toutes les autres zones (346) du manipulateur optique et une aberration minimale en tant que conditions obligatoires pour la définition des courses de réglage de base du vecteur de correction de base.

14. Procédé selon l'une des revendications précédentes, le manipulateur optique (336) contenant une plaque (338) transparente pour le rayonnement d'exposition de l'équipement d'exposition par projection (10), dont l'effet optique est dépendant de la température, les zones (346) sont respectivement des zones séparées pouvant être chauffées électriquement de la plaque (338), et un réglage de l'effet optique pour chaque zone (346) de la plaque (338) transparente étant effectué par un chauffage en fonction des courses de réglage du vecteur de course de réglage corrigé.

15. Équipement d'exposition par projection pour la microlithographie, comprenant :

- un objectif de projection (22) destiné à représenter un masque (12) issu d'un plan d'objet (24) de l'objectif de projection dans un plan d'image (26) de l'objectif de projection ;
- au moins un manipulateur optique (136, 236, 336) dans un trajet de rayon de l'objectif de projection (22), le manipulateur optique possédant une pluralité de zones (146, 246, 346) ayant un effet optique réglable individuellement dans le trajet de rayon (48) et distribuées sur une section transversale du trajet de rayon (48) ;
- un module de définition (54) destiné à définir une erreur de front d'onde dans un champ d'image de l'équipement d'exposition par projection (10) ;
- un générateur de course de réglage (56) destiné à générer un vecteur de course de réglage adapté à la correction de l'erreur de front d'onde avec des courses de réglage pour chaque zone (146, 246, 346) du manipulateur optique (136, 236, 336) au moyen d'un algorithme d'optimisation générant des courses de réglage sur la base de l'erreur de front d'onde définie ;
- un dispositif de contrôle (62, 64) destiné à déterminer un paramètre de limitation concernant la course de réglage pour au moins une zone (146, 246, 346) du manipulateur optique (136, 236, 336) et pour contrôler l'aptitude à l'exécution des courses de réglage du vecteur de course de réglage généré en tenant compte du paramètre de limitation déterminé ;
- un dispositif de correction (66) destiné à corriger le vecteur de course de réglage généré en présence d'une limitation dans l'aptitude à l'exécution d'au moins une course de réglage, le dispositif de correction étant configuré pour acquérir un vecteur de valeur de correction avec des valeurs de correction pour plusieurs des zones (146, 246, 346) du manipulateur optique sur la base du paramètre de limitation et du vecteur de course de réglage généré et pour déterminer un vecteur de course de réglage corrigé en corrigeant les courses de réglage du vecteur de course de réglage généré à l'aide des valeurs de correction correspondantes du vecteur de valeur de correction ; et

un dispositif d'actionnement (50) destiné à régler toutes les zones (146, 246, 346) du manipulateur optique (136, 236, 336) à l'aide du vecteur de course de réglage corrigé en vue de compenser l'erreur de front d'onde.

Fig. 1

Fig. 2

Fig. 3

Fig. 4

Fig. 5

Fig. 6

Fig. 7

Fig. 8

Fig. 9

Fig. 10

Fig. 11

S01 — Berechnen von Basiskorrekturvektoren

S02 — Bereitstellen der Basiskorrekturvektoren

S03 — Überprüfen der Zonen auf Kurzschluss

S04 — Messen oder Extrapolieren des Wellenfrontfehlers

S05 — Generieren eines Stellwegvektors

S06 — Überprüfen der Stellwege für kurzgeschlossene Zonen auf Gleichheit

" = "

S08 — Korrigieren des generierten Stellwegvektors mittels des Basiskorrekturvektors

S07

S09 — Einstellen des Manipulators mit dem korrigierten Stellwegvektor

Einstellen des Manipulators mit dem generierten Stellwegvektor

Fig. 12

S11 — Überprüfen der Zonen auf eingeschränkten Stellwegbereich

S12 — Berechnen des Basiskorrekturvektors

S13 — Bereitstellen des Manipulators und des Basiskorrekturvektors

S14 — Messen oder Extrapolieren des Wellenfrontfehlers

S15 — Generieren eines Stellwegvektors

S16 — Überprüfen des Stellwegs für die fehlerhafte Zone auf Überschreitung des eingeschränkten maximalen Stellwegs

nein

S18 — Korrigieren des generierten Stellwegvektors mittels des Basiskorrekturvektors

S17

S19 — Einstellen des Manipulators mit dem korrigierten Stellwegvektor

Einstellen des Manipulators mit dem generierten Stellwegvektor

Fig. 13

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20080204682 A1
- DE 102011081603 A1
- WO 2011074319 A
- JP 2013161992 A
- JP 2013106014 A
- WO 2008034636 A2
- DE 102012212757 A1
- DE 102012205096 B3
- DE 102008042356 A1
- US 20110216303 A1
- US 20020001088 A1